Europäisches Patentamt

European Patent Office

Office européen des brevets

(19)

(11) **EP 0 481 549 B1**

(12) **FASCICULE DE BREVET EUROPEEN**

(45) Date de publication et mention
de la délivrance du brevet:
**04.09.1996 Bulletin 1996/36**

(51) Int Cl.6: **H04L 27/00**, H04L 1/00

(21) Numéro de dépôt: **91202602.8**

(22) Date de dépôt: **07.10.1991**

(54) **Système et procédé de codage/décodage de signaux numériques transmis en modulation codée**

Kodier/Dekodier-Einrichtung und Verfahren für durch kodierte Modulation übertragene, digitale Signale

Coding/decoding system and method for digital signals transmitted by coded modulation

(84) Etats contractants désignés:
**DE FR GB IT**

(30) Priorité: **09.10.1990 FR 9012417**

(43) Date de publication de la demande:
**22.04.1992 Bulletin 1992/17**

(73) Titulaires:
• **LABORATOIRES D'ELECTRONIQUE PHILIPS S.A.S.**
**94450 Limeil-Brévannes (FR)**
Etats contractants désignés:
**FR**
• **Philips Electronics N.V.**
**5621 BA Eindhoven (NL)**
Etats contractants désignés:
**DE GB IT**

(72) Inventeurs:
• **Chouly, Antoine**
**F-75008 Paris (FR)**

• **Fazel, Khaled**
**F-75008 Paris (FR)**

(74) Mandataire: **Charpail, François et al**
**Société Civile S.P.I.D.**
**156, Boulevard Haussmann**
**75008 Paris (FR)**

(56) Documents cités:
**US-A- 3 988 677**        **US-A- 4 637 021**
**US-A- 4 873 701**

• **IEEE TRANSACTIONS ON COMMUNICATION TECHNOLOGY vol. COM19, no. 4, Août 1971, NEW YORK, US pages 543 - 546; FOX AND HUBAND: 'Implementation of Reed - Solomon erasure - correcting decoder for hybrid coding scheme'**

## Description

L'invention concerne un système de modulation/démodulation de signaux numériques opérant selon une modulation codée en treillis sur un canal de transmission, ledit système comprenant un dispositif de codage muni d'un modulateur situés dans une station émettrice et un dispositif de décodage muni d'un démodulateur et d'un décodeur de canal situés dans une station réceptrice, le dispositif de codage comprenant un codeur de canal qui opère un codage de protection des signaux numériques par ajout de redondance binaire répartie sur plusieurs durées-symbole de la modulaion codée, le codeur de canal comprenant au moins un codeur interne qui opère un codage interne convolutif de rendement R2 combiné à la modulation codée par un organe d'affectation binaire, le décodeur de canal comprenant un décodeur interne comportant au moins un décodeur convolutif.

Elle concerne plus particulièrement le dispositif de codage et le dispositif de décodage dudit système ainsi que le procédé de codage/décodage correspondant.

De tels dispositifs de codage et de décodage trouvent leurs applications dans la transmission de signaux numériques par un canal de transmission.

Il peut s'agir de transmettre des signaux numériques de télévision par exemple à haute définition par un canal satellite ou des signaux numériques par faisceaux hertziens. Il peut s'agir également de transmettre du son par radio mobile, ou des données numériques pour leur stockage par exemple dans un disque compact, un magnétoscope numérique. Dans ces cas il est nécessaire à l'émission d'opérer à la source une réduction préalable de débit par un codeur de source et de rétablir le débit à la réception par un décodeur de source. Dans les cas où l'on désire transmettre des données numériques entre deux unités de traitement numérique, par exemple entre deux calculateurs, cette réduction de débit par un codeur de source ne s'impose pas.

L'application la plus représentative étant celle concernant la télévision haute définition (TVHD) pour laquelle les problèmes sont les plus étendus, la présente demande est présentée pour cette application sans que cela puisse constituer une quelconque limitation.

La numérisation des signaux de Télévision Haute Définition (TVHD) engendre un débit brut total de l'ordre de 800 Mbits/sec. La transmission de ces informations à un tel débit est économiquement irréalisable sur les canaux de transmission existants. Plusieurs techniques de codage pour la réduction du débit (codage de source) ont été développées. Les performances de ces algorithmes de codage se mesurent en terme de leur "facteur de réduction" de débit et de la qualité de l'image restituée après le décodage. Plus on réduit la redondance du signal, plus l'information transmise est signifiante. Les éventuelles erreurs de transmission, qui peuvent assez facilement être corrigées si les informations transmises sont redondantes, ont des conséquences de plus en plus graves lorsque le facteur de réduction augmente.

En conséquence, la transmission des signaux numériques TVHD nécessite une protection judicieuse. Afin de ne pas apercevoir les effets d'erreurs de transmission sur l'écran, le taux d'erreurs en ligne doit être inférieur à $10^{-11}$.

Le canal utilisé pour la "Diffusion Directe par Satellite" (DBS) se caractérise par :

- une largeur de bande de 27 MHz,
- une faible puissance (surtout pour la liaison provenant du satellite) et la présence d'un bruit puissant, considéré comme additif, blanc et gaussien,
- et des distorsions non linéaires.

L'acheminement des signaux numériques de TVHD via un tel canal exige un codage de source à un taux de compression important ainsi qu'une modulation numérique à haute efficacité spectrale.

Les techniques de codage de source, par exemple basées sur une transformation orthogonale, peuvent diminuer le débit par un facteur supérieur à 10 tout en assurant une bonne qualité d'image restituée. Ceci conduit à transmettre un débit binaire de l'ordre de 80 Mbits/s. Mais la transmission de tels signaux sur un canal satellite exige une modulation numérique à efficacité spectrale atteignant 3 bits/s/Hz.

Les techniques de codage et de modulation classiques s'avèrent limitées pour répondre pleinement aux exigences d'une transmission correcte. Cependant ces techniques se sont sensiblement améliorées grâce à la technique de codage proposée par G. UNGERBOECK dans l'article intitulé : "Channel coding with multilevel/phase signals" présenté dans IEEE Transactions on Information Theory vol. IT-28 n°1, January 1982, p.55-67.

Il est proposé de considérer le codage de canal et la modulation comme une entité et pour cela de combiner un codage de canal avec une modulation numérique. Ceci permet d'accroître l'efficacité de la transmission numérique, donc d'améliorer les performances, sans sacrifier l'efficacité spectrale. La redondance ajoutée au codage est transmise par la redondance de l'alphabet au lieu d'accroître le taux de données. Cette technique est basée sur le principe de maximisation de la distance euclidienne minimale entre les séquences de symboles codés transmis. Plus précisément il est proposé à titre d'exemple de transmettre 3 bits par symbole en utilisant une modulation de phase et d'amplitude de deux porteuses en quadrature (MAQ 16).

Ainsi, après un codage qui transforme m bits d'informations en p bits, avec m>p où m-p représente la redondance ajoutée pour la protection d'informations lors de la transmission, avec une modulation à $2^m$ états on dispose de $2^{m-p}$ états supplémentaires pour transmettre cette redondance. Cette technique de modulation permet d'effectuer une répartition spatiale et non pas temporelle de la redondance.

Selon la technique développée dans ce document, lorsque l'on transmet m=3 bits par durée symbole avec 1 bit de redondance ajouté, il est possible d'atteindre un taux d'erreurs binaires (TEB) inférieur à $10^{-11}$, mais il est nécessaire pour cela de disposer à l'entrée d'un rapport signal/bruit meilleur que 12 dB environ. Cette dernière valeur reste très élevée dans des situations réelles car elle impose des antennes de grandes dimensions qui sont inadaptées pour des applications de TVHD destinées au Grand Public.

On connaît le document US 4 873 701 qui décrit un modem et une méthode de modulation-démodulation de signaux codés par un codage en treillis. Il décrit une combinaison d'une modulation codée multidimensionnelle et d'un codage interne convolutif. Le modem utilisé à la réception effectue un décodage de Viterbi. Mais l'efficacité spectrale de 4 bits/s/Hz de ce système reste insuffisante.

Pour les applications en TVHD, le problème qui se pose est donc de déterminer un dispositif de codage augmentant les performances actuelles. A la réception les signaux codés doivent pouvoir être décodés par un dispositif de décodage approprié. L'objectif est d'opérer avec des signaux délivrés par des antennes de dimensions raisonnables présentant un rapport signal/bruit de l'ordre de 9 dB environ pour un débit de 81 Mbit/sec et un taux d'erreurs binaires inférieur à $10^{-11}$, c'est-à-dire un niveau élevé de performances. Cette nécessité d'un haut niveau de performance se retrouve également, partiellement ou en totalité, dans d'autres applications comme par exemple les faisceaux hertziens, les radio-mobiles, le stockage sur compact disque ou sur magnétoscope numérique, la communication entre unités numériques par exemple entre calculateurs, etc...

On connaît également le document US-A-3 988 677 qui décrit un système de codage cascadé comportant un codage interne convolutif et un codage externe en blocs avec une modulation simple QPSK. Ce brevet ne concerne pas une combinaison d'un codage et d'une modulation. Dans ce cas la redondance est transmise au détriment du débit utile. Il utilise un codeur Reed-Solomon qui corrige 16 erreurs et qui est considéré très complexe. L'efficacité spectrale est inférieure à 1. Les débits sont faibles, le taux d'erreurs binaires est élévé, environ $10^{-6}$.

On connaît également le document de "F. W. Fox et F.L. Huband, IEEE Transactions on Communication Technology, vol.1, Com 19, n°4, Août 71, New-York US, pages 543-546", qui décrit un système cascadé dans lequel le codage interne est un codage convolutif et le codage externe est un code unique Reed-Solomon. Le décodage interne suit l'algorithme du décodage séquentiel. Mais il ne décrit pas une combinaison d'un codage et d'une modulation. La redondance ajoutée est transmise au détriment du débit utile. L'efficacité spectrale est inférieure à 1.

On connaît également le document US-A-4 637 021 qui décrit un système de codages cascadés avec des codes interne et externe en blocs cascadés. Les informations sont codées par un code Reed-Solomon, puis entrelacées et à nouveau codées par un autre code Reed-Solomon. A la réception, pour estimer les informations codées, le mécanisme de décodage est effectué en plusieurs passages. Il ne comprend pas une combinaison d'un codage et d'une modulation et la redondance est transmise au détriment du débit utile. Il nécessite deux décodeurs Reed-Solomon entraînant une multiplication de la complexité matérielle. L'efficacité spectrale est inférieure à 1.

La solution au problème posé consiste en ce que le codeur de canal comprend en outre un codeur externe qui opère un codage externe avec un rendement R1, le codeur interne comprenant un codeur différentiel, placé avant le codeur convolutif, pour établir une invariance rotationnelle du codage convolutif, la redondance binaire du codage de protection du codeur de canal étant partagée entre le codeur interne et le codeur externe de sorte que les codages interne et externe concaténés assurent un rendement de codage global R=R1.R2, le décodeur interne étant en série avec un décodeur externe pour décoder ensemble les codages interne et externe concaténés, le décodeur interne comprenant un décodeur différentiel placé après le décodeur convolutif pour effectuer l'inverse de l'opération établissant l'invariance rotationnelle effectuée au codage.

Ainsi avantageusement la combinaison d'une modulation codée avec des codes concaténés permet d'accroître l'efficacité de codage de la transmission sans accroître le taux de transmission et par conséquent sans expansion de la bande. Ceci constitue un compromis entre des performances élevées de transmission et une complexité raisonnable du système de codage.

Pour éviter la perte d'efficacité spectrale on partage la redondance entre un code externe correcteur d'erreurs et un code interne combiné à la modulation.

Pour certaines applications, notamment la transmission de signaux numériques de télévision par satellite, les signaux numériques sont délivrés au codeur de canal par un codeur de source qui opère une réduction de débit.

Pour obtenir une efficacité spectrale de k bits/s/Hz, il est courant d'opérer un codage de k en k+1 bits et d'utiliser une modulation à $2^{k+1}$ états. En concaténant deux codes de rendement global R=$R_1$.$R_2$, on peut de la même manière opérer un codage de k en k+1 bits en partageant la redondance sur les deux codes.

Plus précisément pour obtenir un rendement de codage global R=$3/4$, (soit 3 bits d'information pour un bit de redondance, ce qui est un objectif courant), le codeur de canal opère une concaténation de codes par un codeur externe de rendement $R_1$=$6/7$ suivi d'un codeur interne de rendement $R_2$=$7/8$. Le codeur externe opère un codage en bloc corrigeant les paquets d'erreurs et le codeur interne opère un codage convolutif combiné avec le modulateur. Le codage global de rendement $R=R_1.R_2=3/4$ présente 25% de redondance ajoutée qui sont transmis par la redondance de l'alphabet du modulateur. Globalement par bloc, le codeur externe ajoute 1 bit de protection pour 6 bits d'information ($R_1=6/7$). De même le codeur interne ajoute 1 bit de protection aux 7 bits précédents ($R_2=7/8$). A l'entrée du modulateur il y a donc 8 bits codés dont 2 bits de redondance. Pour l'application TVHD pour laquelle on désire transmettre 3 bits d'information par période T d'horloge (à 27 MHz), il faut donc deux périodes T, soit 2T, pour transmettre les 6 bits d'information c'est-à-dire 8 bits codés.

Une modulation MAQ 16 à deux dimensions (I,Q) permet de transmettre 4 bits par durée symbole. En multiplexant deux MAQ 16 à deux dimensions il est ainsi possible de transmettre deux symboles de 4 bits mis en série au cours de la durée 2T. Le codeur interne va ainsi comprendre un codeur convolutif suivi d'un organe d'affectation pour les deux MAQ16. Avantageusement, ceci permet de transmettre la redondance d'un codage concaténé sans diminuer le débit binaire utile et ceci pour une bande fixe. Du fait de l'utilisation d'une MAQ 16 à 4 dimensions on réduit la redondance binaire équivalente (pour chaque code interne et externe) par durée-symbole T (c'est-à-dire ½ bit par durée-symbole) par rapport à celle des codes précédents (1 bit par durée-symbole). Deux symboles de MAQ16 constituant un bloc, on dispose ainsi d'une redondance de 1 bit par durée-bloc introduite par le codage interne. On peut ainsi utiliser cette réduction de redondance pour l'introduire dans le codage externe.

A la réception le dispositif de décodage va posséder une structure symétrique.

Préférentiellement le décodeur interne comprend un décodeur à maximum de vraisemblance. Celui-ci comprend :

- un organe de détection qui détermine pour chaque bloc reçu un point appartenant à un sous-ensemble de la constellation multidimensionnelle qui soit le plus proche dudit bloc reçu,
- et un décodeur de Viterbi qui opère sur les séquences desdits points.

Les performances des modulations codées dépendent essentiellement de la distance minimale euclidienne (dE) du code utilisé. Il en est de même pour les codes correcteurs d'erreurs pour lesquels la distance de Hamming (dH) intervient. Donc les performances d'un système de deux codes concaténés dépendent essentiellement du produit de leurs distances $d=d_E.d_H$. Le code interne maximise la distance euclidienne minimale et le code externe maximise la distance de Hamming. Ceci prend tout son intérêt dans l'invention du fait de l'utilisation d'une MAQ 16 à 4 dimensions (c'est-à-dire deux MAQ 16 à 2 dimensions). En effet la distance euclidienne $d_E$ d'un code convolutif unique de rendement $6/7$ combiné à une modulation codée à 4 dimensions est bien sûr inférieure à la distance euclidienne minimale obtenue en utilisant un code convolutif unique de rendement $3/4$ combiné à une MAQ 16 à 2 dimensions (à complexité équivalente) (par exemple selon le document cité de G. UNGERBOECK). Mais comme la distance globale du système concaténé est le produit des distances des souscodes, alors avantageusement d est très supérieure à la distance euclidienne dE minimale d'un code à rendement $3/4$ combiné à une MAQ 16 à 2 dimensions.

Pour lever l'ambiguïté de phase de $k\pi/2$ qui peut exister lorsqu'on utilise une MAQ, il est possible, dans certains cas, de disposer de l'information de phase à l'aide d'un récupérateur de phase approprié. Mais généralement cette possibilité n'existe pas et selon l'invention préférentiellement cette ambiguïté de phase de $k\pi/2$ est levée à l'aide d'un codeur interne qui effectue un codage invariant à des rotations de phase de $k\pi/2$ des séquences transmises. Cette dernière solution est réalisée selon l'invention par un codage différentiel préalablement au codage convolutif. Le codeur interne comprend ainsi un codeur différentiel suivi d'un codeur convolutif.

Symétriquement lorsque la situation d'invariance rotationnelle a été traitée à l'émission, le décodeur interne comprend, après le décodeur à maximum de vraisemblance, un décodeur différentiel qui effectue l'inverse de l'opération effectuée à l'émission.

L'invariance rotationnelle du codage se manifeste dans le fait qu'une information, présente à l'entrée du codeur interne, peut subir des rotations de phase de $k\Pi/2$ sans que l'information obtenue en sortie du décodeur interne en soit affectée.

Le codeur externe est préférentiellement déterminé en fonction des solutions (limitant les taux d'erreurs) retenues à la réception pour opérer le décodage des données reçues. Cette détermination tient compte du type d'erreurs susceptibles d'apparaître après le décodage interne. Ainsi si l'on adopte pour le décodage interne un décodeur de Viterbi à la sortie duquel les erreurs sont corrélées, il est alors souhaitable que le codeur externe opère un codage en bloc apte à permettre à la réception la correction de paquets d'erreurs. Pour cela le codeur externe comprend en série un codeur Reed-Solomon RS1, un entrelaceur 1, un codeur Reed-Solomon RS2 et un entrelaceur 2. Les entrelaceurs sont introduits afin qu'à la réception des désentrelaceurs opérant des fonctions inverses soient utilisés pour décorréler les paquets d'erreurs afin de les rendre plus petits et de faciliter ainsi leur correction par un décodeur de type Reed-Solomon.

A la réception les signaux peuvent être traités par un décodeur externe qui comprend deux désentrelaceurs et deux décodeurs Reed-Solomon. Préférentiellement on utilise un seul décodeur Reed-Solomon pour opérer les deux tâches de décodage. En effet, on peut considérer que le canal n'est pas forcément toujours bruité et qu'il existe des intervalles de temps où aucune erreur n'apparaît. Pour décoder les signaux codés à l'émission par deux opérations consécutives de codage de type Reed-Solomon il est donc possible de mettre à profit ces intervalles de temps et de n'utiliser qu'un seul décodeur Reed-Solomon opérant les deux décodages. Ceci nécessite une gestion de priorité entre les deux décodages. Le but des désentrelaceurs est d'adapter les paquets d'erreurs à la capacité de correction du décodeur Reed-Solomon en opérant la décorrélation des paquets d'erreurs.

Il est également possible selon l'invention d'utiliser d'autres modulations codées par exemple une modulation de phase MDP (appelée modulation PSK en langue anglaise).

L'invention sera mieux comprise à l'aide des figures suivantes données à titre d'exemples non limitatifs qui représentent :

figure 1A : un schéma-bloc d'un système de modulation et de codage de signaux numériques,
figure 1B : un schéma-bloc d'un système de démodulation et de décodage de signaux numériques,
figure 2 : un schéma-bloc d'un codeur de canal selon l'invention,
figure 3 : un schéma-bloc d'un codeur interne selon l'invention,
figure 4 : un schéma-bloc représentant l'affectation des blocs de deux symboles $U_1$, $U_2$ dans une constellation à 4 dimensions,
figure 5 : une représentation d'une constellation codée MAQ 16 à 2 dimensions avec l'affectation binaire des symboles,
figure 6 : une représentation de la partition d'une constellation MAQ à 4 dimensions,
figure 7 : une représentation du treillis du code convolutif,
figure 8 : un schéma d'un codeur convolutif de rendement $^7/_8$ selon l'invention,
figure 9 : un schéma d'un codeur différentiel délivrant un codage invariant selon l'invention,
figure 10 : un schéma-bloc d'un codeur externe de rendement $^6/_7$ selon l'invention.
figure 11 : un schéma-bloc d'un décodeur de canal opérant la déconcaténation des codes selon l'invention,
figure 12 : un schéma-bloc d'un décodeur externe,
figure 13 : un organigramme représentant la gestion de décodage mise en oeuvre dans le décodeur externe,
figure 14A : un schéma d'un décodeur externe selon l'invention,
figures 14B, 14C : un chronogramme concernant le schéma de la figure 14A,
figure 15 : un schéma-bloc d'un décodeur interne,
figure 16 : un schéma d'un décodeur différentiel.

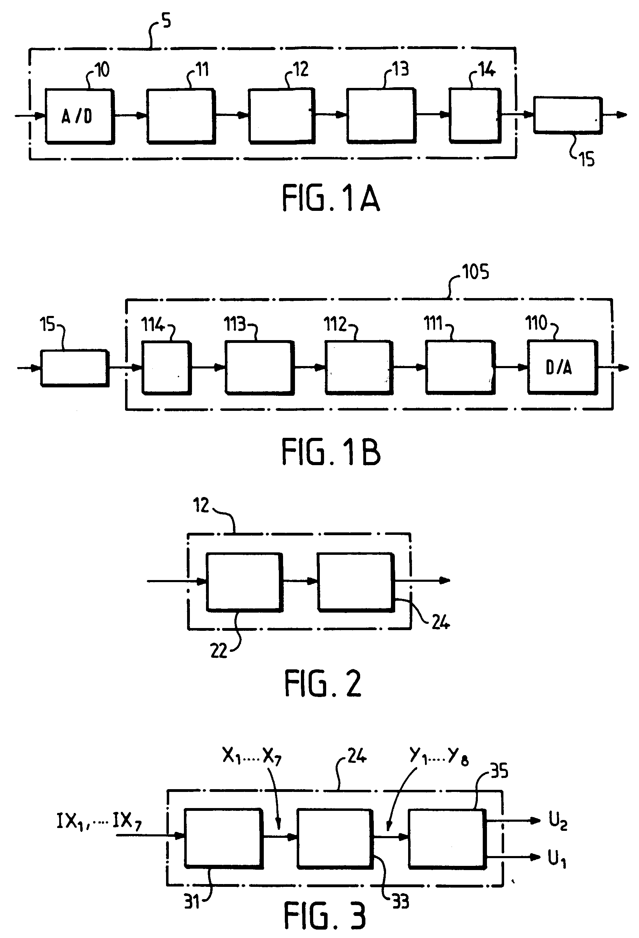

La figure 1A représente un schéma-bloc d'un dispositif de codage 5 de signaux numériques tel qu'il apparaît dans la partie émettrice d'un système de modulation/démodulation. Il comprend en série :

- une source 10, par exemple un convertisseur analogique-numérique, qui délivre les signaux numériques à coder lorsqu'ils ne sont pas déjà disponibles sous forme numérisée,
- un codeur de source 11 (qui peut ne pas exister),
- un codeur de canal 12,
- un modulateur 13,
- un filtre d'émission 14.

Le dispositif de codage est relié au canal de transmission 15. Il peut s'agir de liaisons hertziennes ou de liaisons par câbles.

Pour une application de transmission de signaux TVHD avec un débit binaire des échantillons du signal vidéo de 864 Mbits/s, ce débit binaire est réduit à 81 Mbits/s à la sortie du codeur de source 11. Ces échantillons sont codés par le codeur de canal 12 pour les rendre non vulnérables aux imperfections du canal. Le modulateur 13 adapte ensuite les échantillons numériques au canal de transmission par exemple un canal satellite. La redondance ajoutée (par rapport à une modulation non codée équivalente) par le codeur de canal 12 est transmise par la redondance de l'alphabet de la modulation.

La figure 1B représente le schéma-bloc d'un dispositif de décodage 105 qui effectue à la réception les opérations inverses de celles effectuées à l'émission. Pour cela il comprend (à la sortie du canal 15) :

- un filtre de réception 114,
- un démodulateur 113,
- un décodeur de canal 112,
- un décodeur de source 111 (qui peut ne pas exister),
- un convertisseur numérique-analogique 110 lorsque les signaux numériques sont utilisés sous forme analogique.

Le dispositif de codage 5 (émetteur), le dispositif de décodage 105 (récepteur) et le canal de transmission 15 constituent un système de modulation/démodulation de signaux numériques à modulation codée.

## CODAGE

Selon l'invention, le codeur de canal 12 représenté schématiquement sur la figure 2 comprend un codeur externe 22 placé du côté de la source 10 de signaux numériques et un codeur interne 24 placé du côté du modulateur 13.
Selon l'invention un effectue une concaténation de deux codes, préférentiellement :

- un code externe qui est un code en bloc permettant lors du décodage à la réception de corriger des paquets d'erreurs,
- un code interne qui est un code convolutif combiné avec le modulateur.

La partie qui suit est développée, à titre d'exemple dans le cas d'une application TVHD. Pour disposer par exemple d'une efficacité spectrale de 3 bits/s/Hz, il est courant d'utiliser un codage de protection ajoutant 1 bit de redondance, ce qui se traduit par un rendement $R=^3/_4$. A ce sujet on peut consulter l'article de M.T. LYONS et al. intitulé "16-QAM and treillis-coded 16-QAM on nonlinear channels" IEEE GLOBECOM, NEW-ORLEANS LOUISIANA USA, 1985, page 493. En concaténant deux codes selon l'invention, il est possible d'obtenir ce rendement $R=^3/_4$ par exemple en concaténant des codes de rendement respectifs $R_1=^6/_7$ et $R_2=^7/_8$ (la redondance est alors répartie sur 2 symboles). D'autres répartitions sont également possibles par exemple $R_1=^9/_{10}$ et $R_2=^{10}/_{12}$. Il est également possible d'effectuer une concaténation de plusieurs codes par exemple trois codes tel que $R_1=^9/_{10}$, $R_2=^{10}/_{11}$ et $R_3=^{11}/_{12}$ (dans ces deux cas la redondance est répartie sur 3 symboles). La redondance est alors répartie sur plusieurs symboles du bloc. Dans ces deux derniers exemples la modulation passe ainsi de 4 dimensions à 6 dimensions. Cette répartition permet d'intervenir sur la complexité et les performances du système.

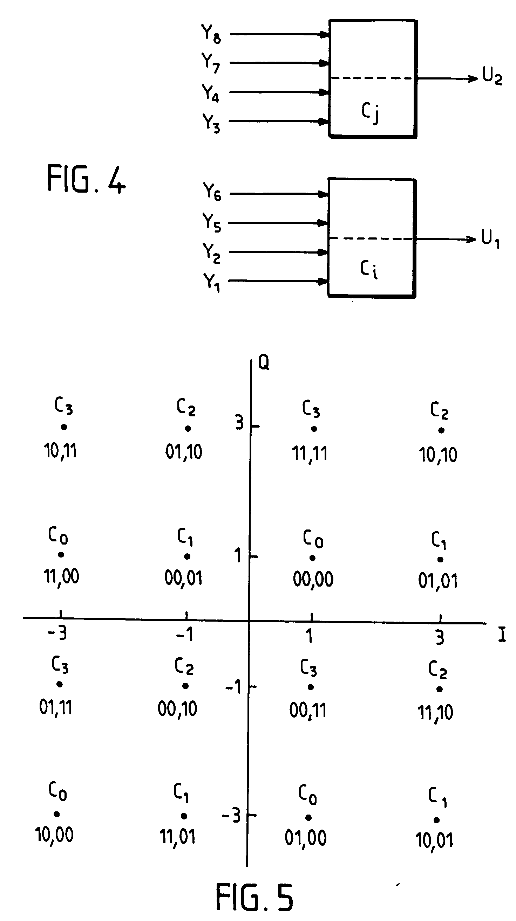

Le codeur externe 22 délivre un code qui ajoute globalement 1 bit de protection à tous les 6 bits d'information ($R_1=^6/_7$). Le codeur interne convolutif 24 ajoute de même globalement 1 bit de redondance à ces 7 bits ($R_2=^7/_8$) codés par le codeur externe 22. Ainsi à l'entrée du modulateur 13 apparaissent 8 bits codés, dont 2 bits représentent la redondance. Pour transmettre les 8 bits codés, conformément à l'invention on utilise une modulation MAQ 16 à 4 dimensions. Ainsi en sortie du modulateur 13 on obtient sur une durée 2T deux symboles de MAQ 16 à deux dimensions (4 bits correspondent à un symbole de MAQ 16). Ces deux symboles (2T) sont ensuite mis en série pour être transmis.
La figure 3 donne le schéma sous sa forme la plus générale d'un codeur interne 24 qui comprend :
- un codeur différentiel 31, un codeur convolutif 33 et un organe d'affectation 35.
Le codeur différentiel 31 a pour but de rendre après décodage les bits d'entrée ($IX_1,...IX_7$) invariants à des rotations de phase de $k\pi/_2$ de la séquence transmise. Ce codeur peut ne pas exister lorsque le problème d'invariance rotationnelle ne se pose pas, par exemple lorsqu'il existe un récupérateur de phase. Les bits de sortie ($X_1,...X_7$) du codeur différentiel 31 sont ensuite codés par le codeur convolutif 33 à 8 états de rendement $^7/_8$. Les 8 bits de sortie ($Y_1,...Y_8$) sélectionnent le bloc $U_1$, $U_2$ dans la constellation à 4 dimensions notée $A_0^{(4)}$ à l'aide d'un organe d'affectation 35. Cette affectation est représentée sur la figure 4. Les 4 bits $Y_1$, $Y_2$, $Y_5$ et $Y_6$ (respectivement $Y_3$, $Y_4$, $Y_7$ et $Y_8$) déterminent le premier symbole $U_1$ du bloc (respectivement le deuxième symbole $U_2$) suivant l'affectation binaire donnée par la figure 5. Parmi ces bits, les deux bits $Y_2$, $Y_1$ (poids faibles) (respectivement $Y_4$, $Y_3$) sélectionnent le sous-ensemble $C_i$ ($i=0,1,2,3$) (respectivement $C_j$) du deuxième niveau de partition de la constellation $A_0$ qui correspond à $U_1$ (respectivement à $U_2$). Les deux bits restants $Y_6$, $Y_5$ (respectivement $Y_8$, $Y_7$) déterminent le symbole $U_1$ (respectivement $U_2$) dans $C_i$ (respectivement $C_j$). L'organe d'affectation peut être constitué d'une PROM.
L'affectation binaire des symboles de la constellation MAQ 16 complète $A_0$ est représentée sur la figure 5. En appelant I et Q respectivement les composantes en phase et en quadrature de la constellation MAQ 16 à 2 dimensions, l'affectation binaire génère 4 sous-ensembles disjoints $C_0$, $C_1$, $C_2$, $C_3$. Le tableau de correspondance entre les symboles de la constellation et l'affectation binaire est le suivant :

- sous-ensemble $C_0$

| I | Q | Affectation binaire |
|---|---|---|
| 1 | 1 | 00,00 |
| 1 | -3 | 01,00 |
| -3 | 1 | 11,00 |
| -3 | -3 | 10,00 |

- sous-ensemble $C_1$

| I | Q | Affectation binaire |
|---|---|---|
| -1 | 1 | 00,01 |
| -1 | -3 | 11,01 |
| 3 | 1 | 01,01 |
| 3 | -3 | 10,01 |

- sous-ensemble $C_2$

| I | Q | Affectation binaire |
|---|---|---|
| -1 | -1 | 00,10 |
| -1 | 3 | 01,10 |
| 3 | -1 | 11,10 |
| 3 | 3 | 10,10 |

- sous-ensemble C3

| I | Q | Affectation binaire |
|---|---|---|
| 1 | -1 | 00,11 |
| 1 | 3 | 11,11 |
| -3 | -1 | 01,11 |
| -3 | 3 | 10,11. |

Les deux bits de poids faible indiquent les sous-ensembles $C_0$, $C_1$, $C_2$, $C_3$. Le premier bit de poids faible indique le premier niveau de partition de la constellation complète $A_0$ :

- "0" si le symbole appartient au sous-ensemble $B_0$ avec $B_0=C_0$ ou $C_2$,
- "1" si le symbole appartient au sous-ensemble $B_1$ avec $B_1=C_1$ ou $C_3$.

Le deuxième bit de poids faible correspond au deuxième niveau de partition de la constellation complète $A_0$,

- "0" si le symbole appartient à $C_0$ ou $C_1$,
- "1" si le symbole appartient à $C_2$ ou $C_3$.

L'établissement d'une telle affectation est opérée dans le souci de maximiser la distance euclidienne minimale. En appelant $d_0$ la distance euclidienne minimale dans $A_0$, on obtient dans les sous-ensembles $B_0$, $B_1$ une valeur $d_1=\sqrt{2}.d_0$ et une valeur $d_2=\sqrt{2}.d_1$ dans les sous-ensembles $C_0$, $C_1$, $C_2$ et $C_3$.

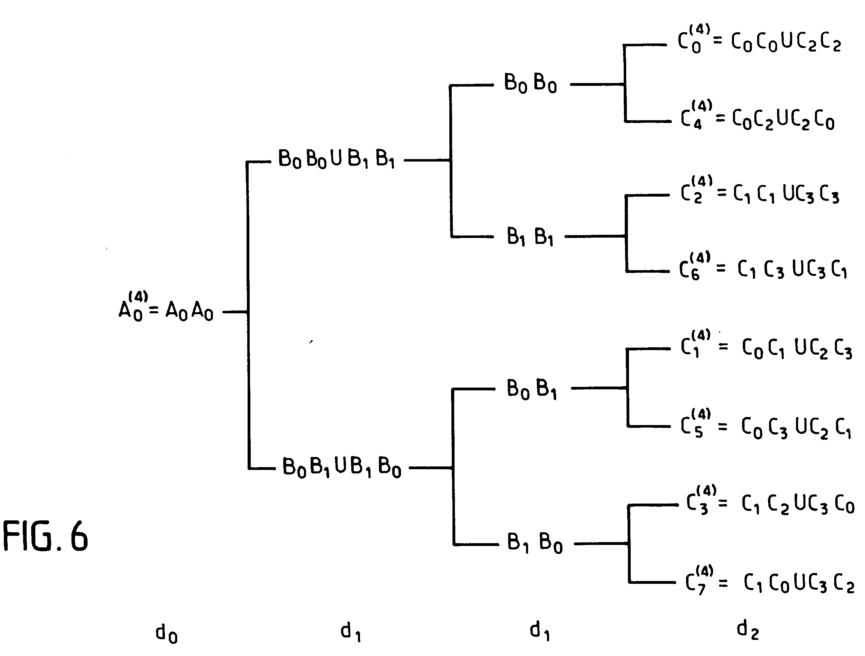

La construction du code est déterminée en tenant compte de la partition de la constellation à 4 dimensions notée $A_0^{(4)}=A_0.A_0$ définie par l'ensemble des blocs de 2 symboles appartenant chacun à une constellation MAQ 16 ($A_0$) à 2 dimensions. La partition $A_0^{(4)}$ est basée sur le deuxième niveau de partition de $A_0$. Elle est donnée par la figure 6. Les distances euclidiennes minimales des 3 niveaux de partition sont respectivement $d_1$, $d_1$ et $d_2$ où $d_1=\sqrt{2}d_0$, $d_2=2d_0$, $d_0$ étant la distance euclidienne minimale dans $A_0$. Au troisième niveau de la partition, on obtient les 8 sousensembles de $C_i^{(4)}$, $i=0$ à 7 de distance euclidienne minimale $d_2$ et vérifiant :

$$d_{2min}^2(U\ C_i^{(4)},\ i\ pair) = d_{2min}^2(U\ C_i^{(4)},\ i\ impair) = d_1^2$$

où U est le symbole mathématique "union".

Pour établir la structure du codeur convolutif il faut tout d'abord déterminer ceux de ses bits d'entrée qui nécessitent un codage compte-tenu du partitionnement voulu en sortie. D'après les figures 5 et 6 on observe que pour sélectionner un sous-ensemble de la forme $C_iC_j$ à la sortie du codeur convolutif, on a besoin de 2 bits pour sélectionner $C_i$ et de 2 bits pour sélectionner $C_j$. Ainsi en codant les bits de poids faibles, il est possible de distinguer l'un des ensembles (par exemple $C_0.C_0$ codé 0000) des autres ensembles qui sont de la forme $C_i.C_j$. Un bloc étant formé de deux symboles appartenant respectivement à deux constellations $A_0$, le codeur convolutif doit donc délivrer 4 bits codés (les 2 bits de poids faible correspondant à chacun des 2 symboles $U_1$ et $U_2$) sur ses 8 bits de sortie. Quatre bits ne sont donc pas codés (les 2 bits de poids fort de chaque symbole). Ils sont donc les mêmes à l'entrée du codeur convolutif. Celui-ci étant prévu pour fournir un rendement $R_2=7/8$, on en déduit que 3 bits d'entrée doivent être codés. Les bits non codés en sortie sont :

- première constellation : $Y_8$, $Y_7$ sont respectivement identiques à $X_7$, $X_6$ en entrée,
- deuxième constellation : $Y_5$, $Y_6$ sont respectivement identiques à $X_4$, $X_5$ en entrée.

Les 4 bits codés en sortie $Y_1$, $Y_2$, $Y_3$, $Y_4$ sont issus des 3 bits d'entrée $X_1$, $X_2$, $X_3$.

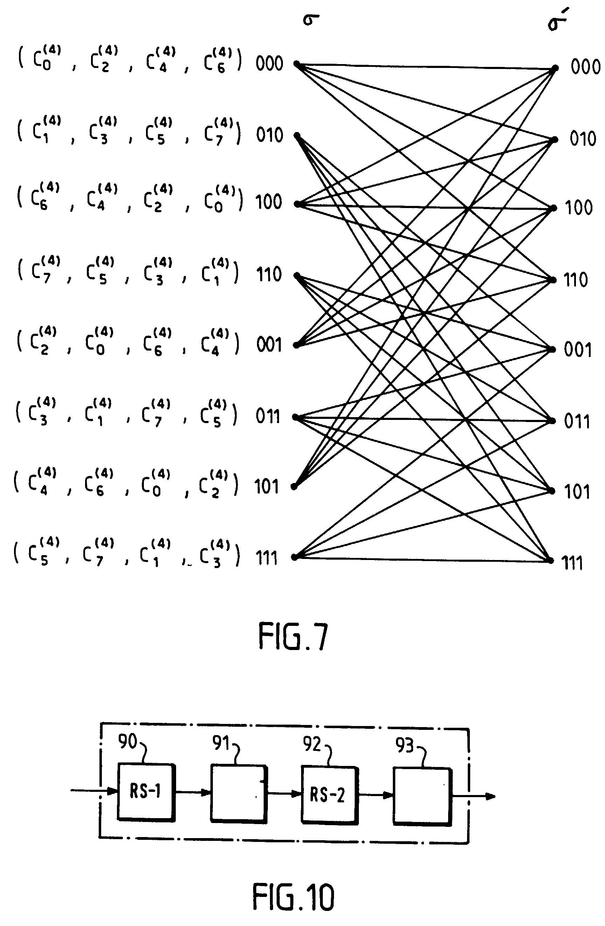

La détermination de la structure du codeur convolutif qui réalise ce codage fait appel à des méthodes connues de l'homme du métier parmi lesquelles on peut citer celle décrite par G. UNGERBOECK dans le document déjà cité. Une solution pour satisfaire la condition de distance euclidienne minimale égale à $d_2$ entre les branches parallèles du treillis du code consiste à retarder $X_1$ de deux durées-bloc et à retarder $X_2$ d'une durée-bloc. En considérant les transitions se présentant respectivement sur les signaux $X_2D$, $X_1D$, $X_1D^2$ (où D est un opérateur-retard), on obtient le treillis représenté sur la figure 7. Ce treillis représente les transitions entre deux états successifs σ, σ' (où σ est l'état présent du codeur défini par $\sigma=(X_2D,\ X_1D,\ X_1D^2)$, et σ' l'état futur.

Aux quatre transitions divergeant d'un état ou convergeant vers un état sont affectés les sous-ensembles $C_i^{(4)}$ d'indices pairs ou impairs, ce qui permet d'assurer une distance euclidienne minimale de $d_1$ entre ces transitions. Ainsi, la distance minimale du code est égale à $d_2$, soit un gain en distance minimale de 6dB par rapport à une modulation non codée de distance minimale $d_0$.

A chaque noeud σ, par exemple le noeud 000, on affecte aux transitions les sous-ensembles $C_0^{(4)}$, $C_2^{(4)}$, $C_4^{(4)}$, $C_6^{(4)}$ c'est-à-dire :

transition de 000 vers 000 affectée à $C_0^{(4)}$
transition de 000 vers 010 affectée à $C_2^{(4)}$
transition de 000 vers 100 affectée à $C_4^{(4)}$
transition de 000 vers 110 affectée à $C_6^{(4)}$

Les bits codés $Y_1$, $Y_2$, $Y_3$, $Y_4$ dépendent des bits codés $X_1$, $X_2$, $X_3$ à l'entrée du codeur, et de l'état du codeur (mémoire du codeur), donc de la sortie des 3 registres placés sur $X_2$ et $X_1$ c'est-à-dire de $X_2D$, $X_1D$ et $X_1D^2$.

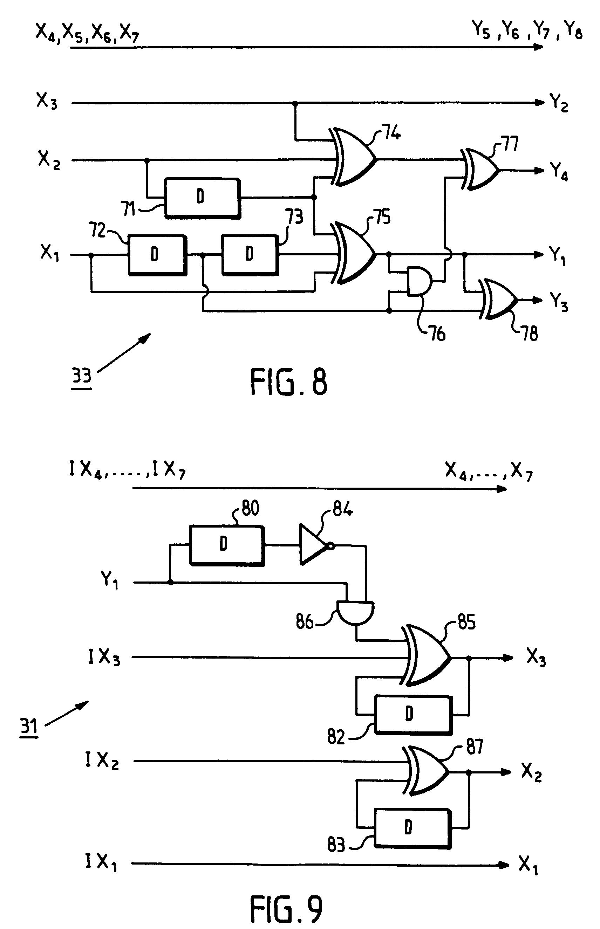

La figure 8 représente le schéma d'un codeur convolutif de rendement $7/8$ où les 3 bits $X_1$, $X_2$, $X_3$ sont codés et les 4 bits $X_4$, $X_5$, $X_6$, $X_7$ ne sont pas codés. Les bits $Y_2$, $Y_1$ et $Y_4$, $Y_3$ sélectionnent les sous-ensembles $C_i$ et $C_j$ de la constellation $A_0$ correspondant aux symboles $U_1$ et $U_2$ respectivement. Les bits non codés $Y_6$, $Y_5$ et $Y_8$, $Y_7$ sélectionnent $U_1$ et $U_2$ dans $C_i$ et $C_j$ respectivement. Le codeur est non linéaire défini selon la méthode connue par les équations :

$$Y_1 = X_2D * X_1D^2 * X_1$$
$$Y_2 = X_3$$

$$Y_3 = X_2D * X_1D * X_1D^2 * X_1$$
$$Y_4 = X_3 * X_2 * X_2D * X_1D.[X_1 * X_1D^2 * X_2D]$$
$$Y_k = X_{k-1}, k = 5, 6, 7, 8$$

où le symbole * représente la fonction "OU-exclusif", et le symbole (.) représente la fonction ET.

Le codeur convolutif 33 comprend :

- un premier opérateur-retard 71 opérant sur $X_2$
- un second opérateur-retard 72 opérant sur $X_1$
- un troisième opérateur-retard 73 opérant sur $X_1$ retardé
- une porte OU-exclusif 74 qui reçoit : $X_3$, $X_2$ et $X_2$ retardé
- une porte OU-exclusif 75 qui reçoit : $X_2$ retardé, $X_1$ et $X_1$ retardé deux fois, et qui délivre $Y_1$,
- une porte ET 76 qui reçoit $X_1$ retardé une fois et la sortie de la porte 75
- une porte OU-exclusif 77 qui reçoit les sorties des 2 portes 74 et 76 et qui délivre $Y_4$
- une porte OU-exclusif 78 qui reçoit les sorties des portes 75 et 72 et qui délivre $Y_3$.

Les bits d'entrée $X_4$, $X_5$, $X_6$, $X_7$ sont non codés et deviennent en sortie du codeur respectivement les bits $Y_5$, $Y_6$, $Y_7$, $Y_8$. Le bit $X_3$ devient le bit $Y_2$.

A ce stade de la détermination de la structure du codeur il est nécessaire de prendre en compte le problème d'invariance rotationnelle du code. On observe sur la figure 5 que ce code n'est pas invariant à des rotations de phase de $k\Pi/2$ mais il vérifie la condition de transparence rotationnelle (voir ci-après). Comme cela a été indiqué précédemment certaines applications peuvent bénéficier d'une récupération de phase pour laquelle le problème d'invariance rotationnelle ne se pose pas. Mais d'autres applications, telles que la transmission d'images de TVHD sur un canal satellite, nécessitent que l'ambiguïté de phase soit levée. L'exemple présenté étant de cette nature, dans l'affectation des sous-ensembles $C_i^{(4)}$ de la constellation indiquée sur la figure 7, cette incidence de la rotation de phase de $\Pi/2$ se traduit par une modification de cette affectation selon la table I.a. : $C_i^{(4)}$ se transforme en $f(C_i^{(4)})$.

Table I.a

| $C_i^{(4)}$ | $f(C_i^{(4)})$ |
|---|---|
| $C_0^{(4)}$ | $C_2^{(4)}$ |
| $C_1^{(4)}$ | $C_3^{(4)}$ |
| $C_2^{(4)}$ | $C_0^{(4)}$ |
| $C_3^{(4)}$ | $C_1^{(4)}$ |
| $C_4^{(4)}$ | $C_6^{(4)}$ |
| $C_5^{(4)}$ | $C_7^{(4)}$ |
| $C_6^{(4)}$ | $C_4^{(4)}$ |
| $C_7^{(4)}$ | $C_5^{(4)}$ |

Afin de rendre le code invariant à des rotations de $k\Pi/2$ il est alors nécessaire de faire précéder le codeur convolutif d'un codeur différentiel qui rétablit cette propriété d'invariance rotationnelle pour les bits d'information à la sortie du décodeur différentiel.

Pour assurer que la transparence rotationnelle soit satisfaite, on définit une fonction $g(\sigma)$ qui s'applique aux états $X_2D$, $X_1D$, $X_1D^2$. Pour cela on définit $g(\sigma)$ tel que $g(\sigma)=(\overline{X_2D}, X_1D, X_1D^2)$ où seul le bit $X_2D$ de $\sigma$ a été inversé comme cela est indiqué sur la table I.b.

Table I.b

| $\sigma=[X_2D, X_1D, X_1D^2]$ | | | $g(\sigma)$ | | |
|---|---|---|---|---|---|
| 0 | 0 | 0 | 1 | 0 | 0 |
| 0 | 0 | 1 | 1 | 0 | 1 |
| 0 | 1 | 0 | 1 | 1 | 0 |
| 0 | 1 | 1 | 1 | 1 | 1 |
| 1 | 0 | 0 | 0 | 0 | 0 |
| 1 | 0 | 1 | 0 | 0 | 1 |
| 1 | 1 | 0 | 0 | 1 | 0 |

Table I.b   (suite)

| $\sigma=[X_2D, X_1D, X_1D^2]$ | | | $g(\sigma)$ | | |
|---|---|---|---|---|---|
| 1 | 1 | 1 | 0 | 1 | 1 |

La transparence rotationnelle est mise en évidence de la manière suivante. Le treillis de la figure 7 indique les transitions d'un état $\sigma$ vers un état $\sigma'$. Les rotations de $\Pi/_2$ (représentées par la fonction f) transforment les sous-ensembles $C_i^{(4)}$ en $f(C_i^{(4)})$ comme indiqué sur la table I.a.

Soit une transition quelconque de $\sigma$ en $\sigma'$. A l'état $\sigma$ correspond après rotation un état $g(\sigma)$, A l'état $\sigma'$ correspond après rotation un état $g(\sigma')$. Il y a transparence rotationnelle lorsque la transition qui fait passer $g(\sigma)$ en $g(\sigma')$ fait également partie du treillis et correspond au sous-ensemble $f(C_i^{(4)})$ obtenu à partir de $C_i^{(4)}$ après une rotation de $\Pi/_2$. Cette condition de transparence rotationnelle est nécessaire pour assurer l'invariance rotationnelle. Elle est assurée par le treillis de la figure 7.

La condition de transparence rotationnelle étant vérifiée, il suffit pour assurer l'invariance rotationnelle de coder différentiellement les 7 bits d'entrée $X_1$ à $X_7$.

D'après les considérations développées précédemment, les bits non codés $X_4$, $X_5$, $X_6$, $X_7$ qui sont issus des bits $Y_5$, $Y_6$, $Y_7$, $Y_8$ (bits de poids forts) sont invariants à des rotations de $k\pi/_2$ (voir figure 5). Donc le codage différentiel ne doit être appliqué qu'aux bits codés $X_1$, $X_2$, $X_3$.

D'après la table I.b, $f(\sigma)$ qui concerne l'état après une rotation de $\Pi/_2$ montre que le bit $X_1$ n'est pas affecté par les rotations. En effet on retrouve dans les deux parties de cette table des bits identiques avant et après rotation pour les opérations portant sur $X_1$ c'est-à-dire $X_1D$ et $X_1D^2$. Comme le bit $X_2$ est inversé après une rotation de $\Pi/_2$ il est nécessaire de le coder différentiellement. Si entre un état $X_2$ à un instant donné et un état antérieur $X_2D$, les bits relatifs à ces états sont les mêmes, on fait correspondre cette situation à l'information $IX_2=0$ (en entrée). Si les bits relatifs à ces états sont différents, on fait correspondre à cette situation l'information $IX_2=1$ (en entrée). Ceci donne le codage différentiel défini par :

$$X_2 = IX_2 * X_2D.$$

avec

$IX_2 \to$ bit d'entrée

$X_2 \to$ bit de sortie

Le codage différentiel du bit $X_3$ est réalisé de la façon suivante. D'après la figure 8, le bit $X_3$ est identique au bit $Y_2$ qui affecte uniquement le symbole $U_1$ (premier symbole du bloc). Le bit $Y_2$ est le deuxième bit de poids faible (à partir de la droite) sur la figure 5 ($Y_2=0$ si $U_1$ appartient à $C_0$ ou $C_1$, $Y_2=1$ si $U_1$ appartient à $C_2$ ou $C_3$). En effectuant une rotation de $k\pi/_2$, on observe que le sous-ensemble $C_i$, i=0,1,2,3 se transforme en $C_{(i+k)mod.4}$ (figure 5). Ainsi par exemple le sous-ensemble $C_0$ devient $C_1$ après une rotation de $\Pi/_2$.

En affectant les sous-ensembles $C_i$ (respectivement $C_{i^-}$) au symbole $U_1$ (respectivement le symbole $U_1$ retardé $U_1$-), le codage différentiel du bit $X_3$ est défini tel que :

$IX_3 = 0$ si i=i⁻ ou i=(i⁻+1) mod.4

$IX_3 = 1$ si i=(i⁻+2) mod.4 ou i=(i⁻+3) mod.4

soit $X_3 = IX_3 * X_3D * Y_1.\overline{Y_1D}$

pour assurer l'invariance rotationnelle.

$IX_3 \to$ bit d'entrée

$X_3 \to$ bit de sortie

$Y_1 \to$ premier bit de poids faible correspondant au premier symbole du bloc ($U_1$).

Après ce codage différentiel $IX_3$ devient invariant. En effet, une rotation de la séquence émise de $k\Pi/_2$ incrémente les indices i et i⁻ de la même valeur k.mod 4 et par suite le bit $IX_3$ reste inchangé. C'est la différence des indices i qui contient l'information. Comme $Y_2=X_3$, $X_3$ est le bit affecté au deuxième niveau de la partition de $A_0$ et correspond au premier symbole $U_1$ du bloc, c'est-à-dire : $X_3=0$ si $U_1$ appartient à $C_0$ ou $C_1$ et $X_3=1$ si $U_2$ appartient à $C_2$ ou $C_3$.

Le schéma du codeur différentiel est donné sur la figure 9. Il comprend :

- un premier opérateur-retard 80 opérant sur $Y_1$ (sortie du codeur convolutif) suivi d'un inverseur 84,
- un second opérateur retard 82 opérant sur la sortie $X_3$,
- un troisième opérateur retard 83 opérant sur la sortie $X_2$,
- une porte ET 86 qui reçoit la sortie de l'inverseur 84 et $Y_1$,
- une porte OU-exclusif 85 qui reçoit la sortie de la porte ET 86, la sortie de l'opérateur-retard 82 et l'entrée $IX_3$ et qui délivre le bit codé $X_3$,
- une porte OU-exclusif 87 qui reçoit la sortie de l'opérateur-retard 83 et l'entrée $IX_2$, et qui délivre le bit codé $X_2$.

Les entrées $IX_1$, $IX_4$, $IX_5$, $IX_6$, $IX_7$ ne sont pas codées et correspondent respectivement aux bits de sortie $X_1$, $X_4$, $X_5$, $X_6$, $X_7$.

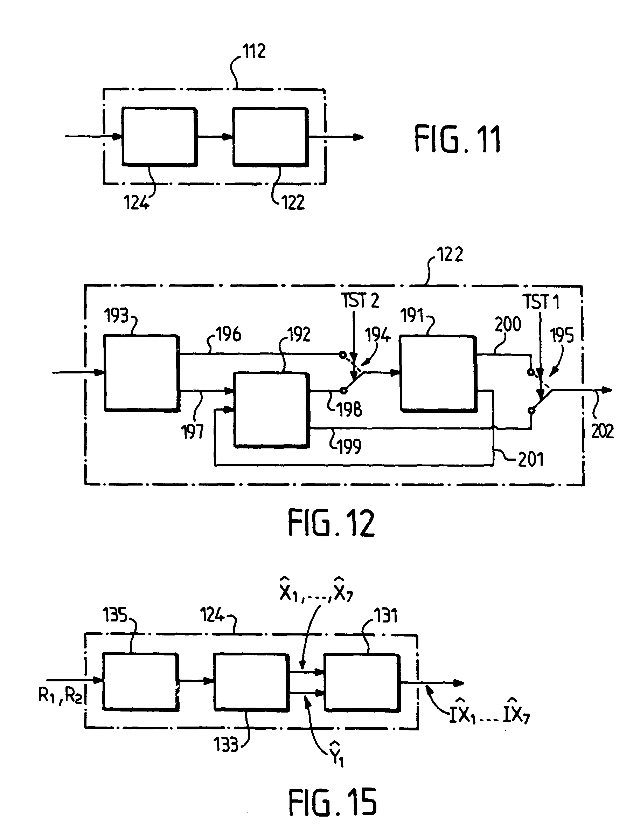

Devant le codeur interne 24 qui vient d'être décrit est disposé un codeur externe 22 de rendement $^6/_7$. Il ajoute globalement un bit de redondance à 6 bits d'informations. Il comprend (figure 10) en série un premier codeur Reed-Solomon 90, un premier entrelaceur 91, un second codeur Reed-Solomon 92 et un second entrelaceur 93 qui délivre les bits codés. Le choix de ces codeurs réside dans leur capacité à corriger à la réception des paquets d'erreurs. Ces codeurs sont en eux-mêmes de type connu et ne seront pas détaillés ici. Ces codes Reed-Solomon sont par exemple décrits dans : "Theory and practice of error control codes" R. BLAHUT, Addison-Wesley Publishing Company, mai 1984. Pour des applications en TVHD, il est par exemple possible d'utiliser un premier code RS1 de longueur N1=52 symboles parmi lesquels $K_1$=48 symboles représentent les symboles d'information. Chaque symbole de ce code possède q=7 bits. Ce choix est lié au fait qu'à la réception il est intéressant d'utiliser un seul décodeur interne de Viterbi qui délivre les symboles de 7 bits. Le deuxième code RS2 est par exemple un code de longueur N2=56 symboles parmi lesquels $K_2$=52 symboles représentent les symboles d'information. Chaque symbole de ce code possède q=7 bits.

Ces deux codes sont capables de corriger chacun deux symboles d'erreurs. Les entrelaceurs 91 et 93 sont des entrelaceurs en bloc. Ils permettent de décorréler les paquets d'erreurs afin de faciliter à la réception leurs corrections par un seul décodeur Reed-Solomon. Cela consiste d'abord à écrire ligne par ligne puis à lire colonne par colonne des symboles de q=7 bits dans un tableau de dimensions lxl. Ce tableau peut être stocké dans une RAM. En sortie du codeur les symboles d'information ont une position bien déterminée dans la séquence de N symboles. Les N-K symboles de contrôle se présentent les premiers suivis par les K symboles d'information. Les mots de code peuvent être obtenus par une multiplication polynômiale entre un polynôme générateur g(x) et un polynôme d'information inf(x).

A titre d'exemple pour une transmission de TVHD sur un canal satellite à 27 MHz, le codeur externe 22 (figure 2) reçoit des symboles avec un débit de 81 Mbits/s à une fréquence-symbole de 11,57 MHz (7 bits par symbole). A la sortie du premier codeur Reed-Solomon 90 (figure 10), le débit est de 87,75 Mbits/s à une fréquence symbole de 12,53 MHz (7 bits par symbole). A la sortie du deuxième codeur Reed-Solomon 92, le débit est de 94,5 Mbits/s avec une fréquence symbole de 13,5 MHz (7 bits par symbole). A la sortie du codeur convolutif 33 (figure 3) le débit est de 108 Mbits/s à une fréquence symbole de 13,5 MHz (8 bits par symbole). On dispose alors en sortie de l'organe d'affectation des deux symboles $U_1, U_2$ qui sont transmis successivement par le modulateur, à la fréquence de 27 MHz. L'efficacité spectrale globale est de :

$$\frac{81 \text{ Mbits/s}}{27 \text{ MHz}} = 3 \text{ bits/s/Hz}.$$

En suivant ce qui vient d'être présenté, l'homme du métier peut établir d'autres affectations binaires d'une constellation $A_0$ à 2 dimensions et d'autres partitions d'une constellation $A_0^{(4)}$ à 4 dimensions et établir un code convolutif et si nécessaire un code différentiel qui concaténés avec un code externe permettent de disposer d'une grande distance euclidienne minimale en respectant si nécessaire l'invariance rotationnelle.

## **DECODAGE**

Pour opérer la déconcaténation des codes concaténés à l'émission par le codeur externe et le codeur interne du codeur de canal, il faut à la réception disposer en série un décodeur interne 124 et un décodeur externe 122 formant le décodeur de canal 112 (figure 11).

Pour extraire l'information, le décodeur externe 122 effectue des opérations inverses de celles effectuées au codage par deux codeurs Reed-Solomon RS1 et RS2. L'opération de décodage Reed-Solomon pour la correction d'erreurs est basée sur des tests. Ces tests ont pour but de détecter les erreurs dans les "mots-code" reçus. Lorsqu'il n'y a pas d'erreur, les informations sont extraites du mot-code, grâce à la structure particulière de celui-ci (les symboles d'information ont une position bien déterminée dans le mot-code). Si le mot reçu est erroné, il est envoyé vers le décodeur Reed-Solomon afin de corriger les erreurs. Le décodeur Reed-Solomon délivre ainsi le "mot-code" corrigé et les informations sont alors extraites du "mot-code" corrigé.

Deux tests sont effectués :

- un test TST1 pour détecter les erreurs dans les mots reçus codés par RS1,
- un test TST2 pour détecter les erreurs dans les mots reçus codés par RS2.

Lorsque des erreurs sont détectées dans les mots reçus issus du codage RS1, l'opération du décodage Reed-Solomon est effectuée pour corriger les erreurs. De même lorsque des erreurs sont détectées dans les mots reçus issus du codage RS2, l'opération du décodage Reed-Solomon est effectuée pour corriger les erreurs.

Dans certains intervalles de temps, aucune erreur n'est détectée dans les mots reçus de RS1 (respectivement RS2). Dans ces cas, le décodeur Reed-Solomon au lieu d'être laissé "dormant" peut corriger dans ces intervalles de temps les erreurs éventuelles détectées dans RS2 (respectivement RS1).

Comme cela a été précisé précédemment il n'est donc pas nécessaire de donner au décodeur externe une structure totalement symétrique de celle du codeur externe. En particulier bien que le codeur externe utilise deux codeurs Reed-Solomon RS1 et RS2 il est possible de n'utiliser à la réception qu'un seul décodeur Reed-Solomon en mettant à profit ces intervalles de temps où aucune erreur n'apparaît. Par exemple pour un TEB=10$^{-4}$ en sortie du décodeur interne, le décodage du code RS2 n'utilise que 2% du temps (taux d'erreurs $\simeq$ 1 bloc sur 50) et le décodage du code RS1 utilise seulement 0,065% du temps (taux d'erreurs $\simeq$ 1 bloc sur 1538). Un seul décodeur est donc suffisant, mais une gestion d'adressage et de priorité de décodage s'avère nécessaire car le TEB sur les blocs reçus du code RS2 est supérieur au TEB sur les blocs reçus du code RS1. Le décodage de RS1 est donc prioritaire devant le décodage de RS2 si les deux mots reçus sont "simultanément" erronés. Pour faire fonctionner en parallèle le décodage des codes RS1 et RS2, la stratégie adoptée ici est de travailler sur les macro-blocs de n mots-code avec une gestion de priorité. Le choix de n dépend de la minimisation de la probabilité d'avoir plusieurs blocs de mots de codes RS1 et RS2 consécutifs simultanément erronés.

En appelant n=n1+n2

où

n1=nombre de blocs consécutifs erronés de code RS1,

n2=nombre de blocs consécutifs erronés de code RS2 il faut choisir n tel que :

$$P_1^{n1} + P_2^{n2} \le P$$

où $P_1$ représente la probabilité d'erreurs sur les blocs de RS1,

$P_2$ représente la probabilité d'erreurs sur les blocs de RS2. Si on choisit P=10$^{-15}$ et TEB=10$^{-4}$, alors :

n2$\ge$9, n1$\ge$5 soit n1+n2$\ge$14

Donc n=14 peut être choisi pour opérer le décodage des signaux correspondant aux contraintes préalablement exposées dans l'exemple choisi. Ce choix de la valeur de n signifie qu'il n apparaîtra aucun conflit de correction si les mots reçus sont "simultanément" entachés d'erreurs sur les deux codes.

Le schéma-bloc du décodeur externe 122 est représenté sur la figure 12. Il comprend un premier étage 193 qui effectue un premier désentrelacement suivi d'un décodeur Reed-Solomon 192 puis d'un second étage 191 qui effectue un second désentrelacement. Plus précisément il comprend :

- un premier étage 193 qui effectue, pour le premier codage, un premier désentrelacement et qui sépare entre eux des premiers blocs erronés 197 et des premiers blocs corrects 196,
- un premier organe de test qui détermine un nombre de premiers blocs erronés et qui délivre un signal de test TST2,
- un décodeur Reed-Solomon 192 qui reçoit lesdits premiers blocs erronés 197 du premier étage et fournit des premiers blocs corrigés 198,
- un premier commutateur 194, commandé par le signal TST2, qui commute lesdits premiers blocs corrects 196 et lesdits premiers blocs corrigés 198 vers un second étage 191,
- un second étage 191 qui effectue, pour le codage suivant, un second désentrelacement et qui sépare entre eux des seconds blocs erronés 201 et des seconds blocs corrects 200, lesdits seconds blocs erronés 201 étant introduits à l'entrée du décodeur Reed-Solomon 192 qui délivre des seconds blocs corrigés 199,
- un second organe de test qui détermine un nombre de seconds blocs erronés et qui délivre un second signal de test TST1,
- un second commutateur 195, commandé par le signal TST1, qui commute vers une sortie 202, lesdits seconds blocs corrects 200 et lesdits seconds blocs corrigés 199, le décodeur Reed-Solomon corrigeant en priorité les seconds blocs erronés lorsque les premiers blocs erronés et des seconds blocs erronés antérieurs requièrent simultanément

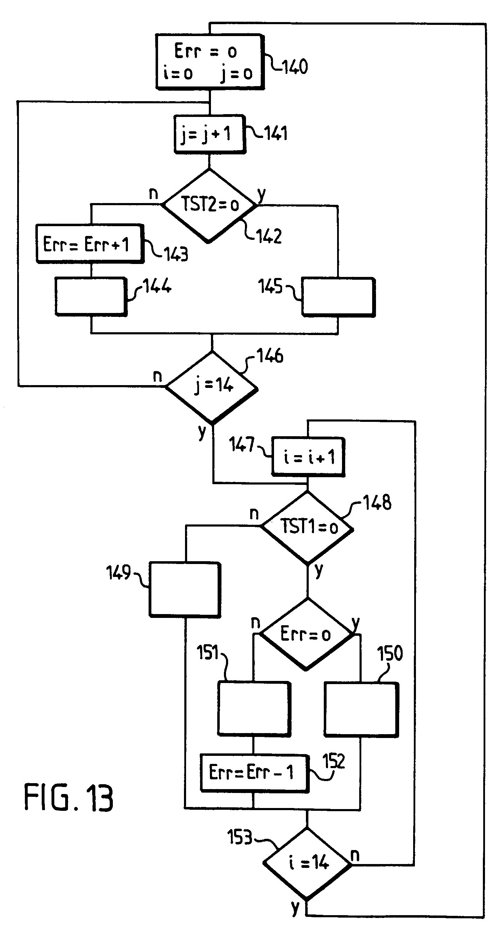

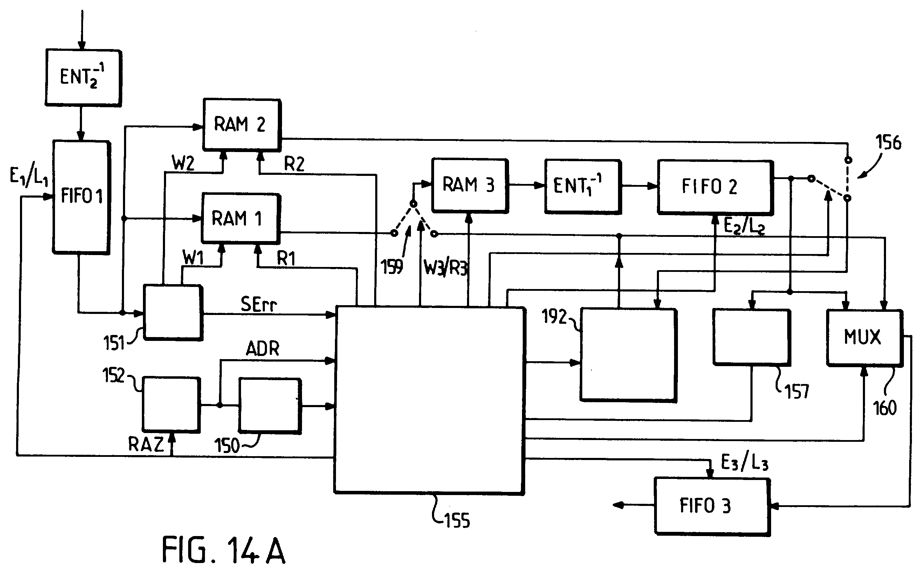

La gestion des priorités est décrite par l'organigramme de la figure 13.

- l'étape 140 indique l'initialisation. Il y a introduction de 14 blocs sur lesquels vont être effectués les tests d'erreurs. Deux compteurs de blocs sont initialisés, (i=0,j=0), concernant des boucles relatives à deux tests, TST1 et TST2. Un compteur du nombre d'erreurs détectées est mis à zéro : Err=0,

Une boucle concernant un premier test est exécutée.

- étape 141. Le compteur j de blocs est incrémenté d'une unité.
- étape 142. Le test TST2 est effectué. Il consiste à détecter selon le code RS2 les erreurs dans les blocs reçus et pour cela il détermine le résultat de la division du mot reçu V(x) par le polynôme générateur g(x). Si le reste de la division égale zéro, alors il n'y a pas d'erreur (TST2=0, symbole y). Si le reste de la division est différent de zéro alors une erreur est détectée (TST2$\ne$0, symbole n) et le compteur du nombre d'erreurs est incrémenté (étape 143). Les blocs erronés et ceux non erronés sont placés en mémoire (respectivement étapes 144 et 145). Le test TST2 s'opère ainsi jusqu'à ce que la totalité des 14 blocs ait été examinée (étape 146).

Une seconde boucle concernant un second test TST1 est alors exécutée.

- étape 148. Le test TST1 porte sur la détection d'erreurs selon le code RS1 selon également une division par un polynôme générateur. Si des erreurs sont détectées (TST1≠0, symbole n) il y a en priorité mise en oeuvre du décodage du code RS1 et extraction des informations de RS2 dans les blocs de données non erronés (étape 149),
- si aucune erreur n'est détectée (TST1=0, symbole y) il y a un test pour déterminer la valeur Err du nombre d'erreurs détectées lors de TST2,
- si Err=0, il y a extraction des informations de RS1 et de RS2 dans les blocs de données non erronés (étape 150),
- si Err≠0, il y a décodage selon le code RS2 et extraction des informations selon RS1 (étape 151). La valeur de Err est décrémentée d'une unité (étape 152).

L'étape 153 détermine si l'ensemble des blocs a été testé (ici 14 blocs) :

. si i≠14 le traitement se poursuit par l'étape 147 avec incrémentation du compteur i de blocs,
. si i=14 le traitement des 14 blocs est terminé et un autre cycle portant sur un autre lot de 14 blocs est repris à l'étape 140.

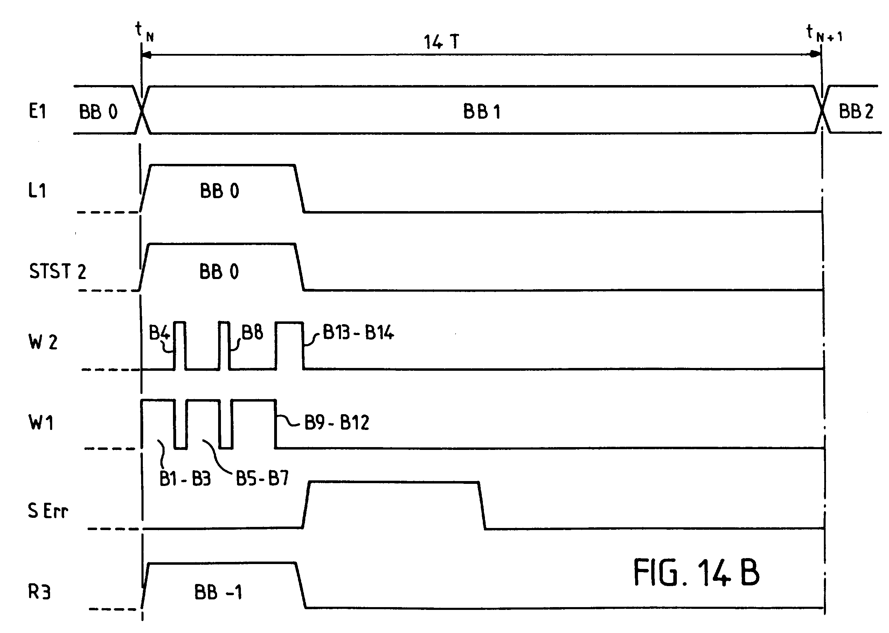

La figure 14A représente un schéma-bloc du décodeur externe correspondant à l'organigramme de gestion de la figure 13.

A la sortie du désentrelaceur $ENT_2^{-1}$ (qui reçoit les signaux à décoder) se trouve une mémoire FIF01 qui stocke à chaque cycle 14 blocs de données qui sont soumis au test TST2 dans l'organe de test 151. L'incrémenteur 152 compte à chaque fois le nombre de blocs traités (compteur j). Les blocs erronés (TST2≠0) sont écrits (signal W2) dans une mémoire RAM2 et les blocs corrects (TST2=0) sont écrits (signal W1) dans une mémoire RAM1. Les adresses ADR des blocs erronés et des blocs corrects écrits dans les deux mémoires, sont transmises par l'incrémenteur 152 à une unité de gestion 155. Celle-ci reçoit également un signal d'erreurs SErr qui indique que des erreurs ont été détectées.

Un comparateur 150 teste si le nombre de blocs (ici j=14) a été atteint. Il émet alors une commande à l'unité de gestion 155. Un seul décodeur RS 192 est utilisé pour opérer sur les données erronées. Celles-ci sont issues (commutateur 156) soit de la mémoire RAM2 qui stocke des données erronées (après $ENT_2^{-1}$) soit d'une mémoire FIF02 (après $ENT_1^{-1}$). L'organe de test (TST1) 157 permet à travers l'unité de gestion 155 de commander le commutateur 156. Une mémoire RAM3 placée avant le désentrelaceur $ENT_1^{-1}$ est chargée (signal W3) soit avec les données testées bonnes issues de la mémoire RAM1, soit avec les données erronées après le test TST2 (mémoire RAM2) mais qui ont été corrigées par le décodeur RS 192. Un commutateur 159 assure cet aiguillage commandé par l'unité de gestion 155. En fin de traitement, un multiplexeur 160 permet de délivrer dans l'ordre correct à une mémoire FIF03 les données qui n'ont pas subi de correction et les données qui ont subi une correction par le décodeur RS 192. Lorsque les 14 blocs placés initialement dans la mémoire FSF01 ont été traités, l'unité de gestion 155 émet un signal de remise à zéro RAZ à l'incrémenteur 152 et un signal d'écriture de 14 nouveaux blocs à la mémoire FIF01.

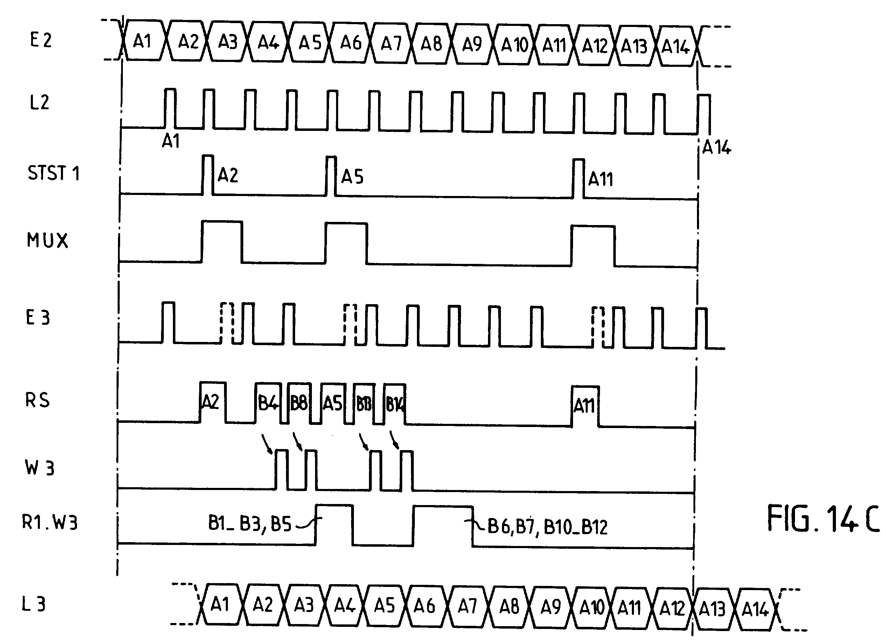

La manière dont les blocs de données sont traités par le décodeur externe est représentée par le chronogramme des figures 14B et 14C. Il correspond à un cycle de 14T (entre $t_N$ et $t_{N+1}$) où T est la durée d'un bloc. La valeur 14 est ici prise à titre d'exemple.

Sur la figure 14B on trouve de haut en bas :

1 - le signal d'écriture $E_1$ d'un macro-bloc BB1 de 14 blocs dans la mémoire FIF01. Le macro-bloc BB1 est précédé (respectivement suivi) d'un macro-bloc BB0 (respectivement BB2). Cette écriture est faite à la fréquence $f_{S2}$=13,5 MHz qui est la fréquence-symbole de décodage correspondant au codage RS2.

2 - le signal de lecture L1 du macro-bloc BB0 à partir de la mémoire FIF01. Cette lecture est opérée à une fréquence f plus élevée que la précédente : par exemple f=4x$f_{s2}$=54MHz. La mémoire FIF01 est pour cela organisée en deux parties qui opèrent en alternance.

3 - avec un léger retard sur le signal de lecture L1 un signal de test STST2 est délivré. Au cours de ce test certains blocs vont être testés corrects et d'autres erronés.

4 - à titre d'exemple, les blocs $B_4$, $B_8$, $B_{13}$, $B_{14}$ sont testés erronés. Un signal d'écriture $W_2$ est émis pour les écrire dans la mémoire RAM2.

5 - de la même manière les blocs $B_1$ à $B_3$, $B_5$ à $B_7$ et $B_9$ à $B_{12}$ sont testés corrects. Un signal d'écriture $W_1$ est émis pour les écrire dans la mémoire RAM1.

6 - à la suite de cela un signal d'erreur SErr est transmis à l'unité de gestion 155 pour mettre en oeuvre une procédure de décodage (correction d'erreurs).

7 - au début du cycle de 14T un signal de lecture R3 est émis pour lire la mémoire RAM3 qui contient les échantillons corrects issus de RAM1 et les échantillons corrigés issus du décodeur RS. Cette lecture opère sur le macro-bloc antérieur $BB_{-1}$ qui a subi une partie du traitement au cours du cycle précédent.

Les blocs issus de la mémoire RAM3 entrent dans le désentrelaceur $ENT_1^{-1}$ à une fréquence-symbole $f_{S1}$=12,53MHz. Ce traitement qui consiste comme pour l'entrelacement à opérer une lecture et une écriture dans un tableau (lxl), dure un certain nombre de cycles.

8 - Au début du cycle de 14T (indiqué sur la figure 14B), la mémoire FIF02 reçoit (figure 14C) un signal d'écriture E2 de blocs beaucoup plus antérieurs qui viennent d'être désentrelacés. Ces blocs $A_1$ à $A_{14}$ sont représentés en haut de la figure 14C. On trouve également de haut en bas :

9 - un signal de lecture L2 de la mémoire FIF02 à la fréquence-symbole de traitement f=54MHz.

10 - avec un léger retard sur le signal de lecture L2 un signal de test STST1 est délivré qui permet de déterminer les blocs erronés, par exemple $A_2$, $A_5$, $A_{11}$. Le test TST1 bénéficie d'une priorité comme cela a été exposé au préalable. Ces symboles erronés sont donc commutés vers le décodeur RS.

11 - le décodage RS s'effectue très rapidement et le multiplexeur (signal MUX) permet de replacer les symboles $A_2$, $A_5$, $A_{11}$ après correction dans leur groupe de symboles (représentés en pointillés sur E3).

12 - un signal d'écriture E3 permet d'écrire les symboles des blocs $A_1$ à $A_{14}$ dans la mémoire FIF03.

13 - ces symboles peuvent alors être lus (signal L3) dans la mémoire FIF03 à une fréquence $f_s$=11,57MHz qui est la fréquence-symbole à la sortie du décodeur externe. Un symbole étant codé sur 7 bits on obtient un débit de 81Mbits/s.

Comme cela a été indiqué précédemment, le décodeur RS sert au décodage successif du code RS1 et du code RS2. Sur la figure 14C le label RS indique la manière selon laquelle les symboles erronés issus des deux codes sont imbriqués. Le test TST1 étant prioritaire les symboles de type A sont ici prioritaires, $A_2$ est donc corrigé en premier. La durée entre les blocs erronés $A_2$ et $A_5$ étant assez grande, le décodeur RS effectue alors la correction sur les blocs $B_4$ et $B_8$ et ainsi de suite.

Les blocs de type B après correction sont écrits dans la mémoire RAM3 pour la poursuite du traitement de désentrelacement $ENT_1^{-1}$. Le signal $W_3$ contrôle les échanges entre le décodeur RS et RAM3 et le signal $R_1.W_3$ contrôle les échanges entre RAM1 et RAM3.

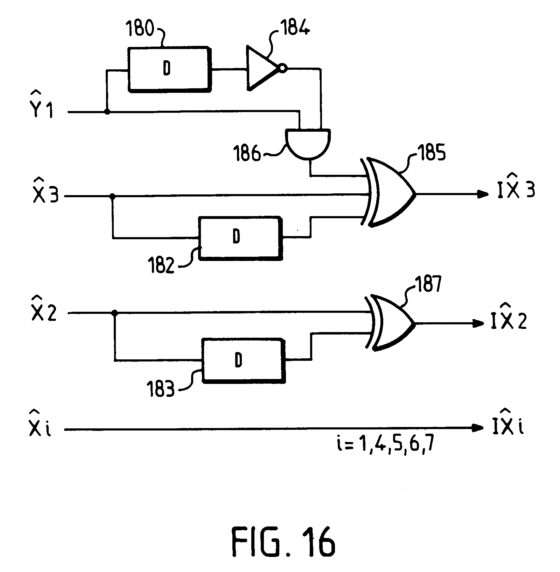

La figure 15 représente le schéma-bloc d'un décodeur interne 124 selon l'invention. Il comprend un organe de détection 135 qui détermine le point le plus proche du bloc reçu $(R_1,R_2)$ dans chacun des sous-ensembles $C_i^{(4)}$, i=0,... 7 de la constellation $A_0^{(4)}$. Pour cela il détermine la métrique du bloc reçu $(R_1,R_2)$ dans chacun des 8 sous-ensembles, la métrique étant définie par le carré de la distance euclidienne entre le bloc $(R_1,R_2)$ et le point le plus proche dans $C_i^{(4)}$. Cette opération peut être réalisée à l'aide d'une PROM.

Les métriques et les points estimés issus de l'organe de détection 135 sont ensuite traités par un décodeur à maximum de vraisemblance par exemple un décodeur de Viterbi 133. Comme pour le codeur de Viterbi, la réalisation d'un décodeur de Viterbi est connue par exemple du manuel déjà cité. Pour l'exemple présenté dans l'invention (code convolutif à 8 états) ceci nécessite 32 additions et 24 comparaisons par durée-bloc. A la sortie du décodeur de Viterbi on obtient des données estimées $\hat{X}_1...\hat{X}_7$ et $\hat{Y}_1$ avec un certain retard. Lorsque les signaux ont été traités par un codeur différentiel pour des nécessités d'invariance rotationnelle, il est alors nécessaire d'utiliser un décodeur différentiel 131 pour opérer le décodage différentiel et obtenir en sortie les données $I\hat{X}_1,...,I\hat{X}_7$.

En considérant l'exemple de réalisation décrit pour le codage différentiel, le décodeur différentiel opère un décodage selon les relations :

$$I\hat{X}_2 = \hat{X}_2 * \hat{X}_2 D$$

$$I\hat{X}_3 = \hat{X}_3 * \hat{X}_3 D * \hat{Y}_1 . \overline{\hat{Y}_1 D}$$

$$I\hat{X}_i = \hat{X}_i \quad i = 1, 4, 5, 6, 7.$$

Le symbole * représente la fonction "OU-exclusif",
et le symbole (.) représente la fonction ET.

Le schéma du décodeur différentiel est donné sur la figure 16. Il comprend :

- un premier opérateur-retard 180 opérant sur $\hat{Y}_1$ (entrée du décodeur de Viterbi) suivi d'un inverseur 184,
- un second opérateur-retard 182 opérant sur l'entrée $X_3$,
- un troisième opérateur-retard 183 opérant sur l'entrée $X_2$,

- une porte ET 186 qui reçoit la sortie de l'inverseur 184 et $\hat{Y}_1$,
- une porte OU-exclusif 185 qui reçoit la sortie de la porte ET 186, la sortie de l'opérateur-retard 182 et l'entrée $\hat{X}_3$ et qui délivre le bit décodé $IX_3$,
- une porte OU-exclusif 187 qui reçoit la sortie de l'opérateur-retard 183 et l'entrée $\hat{X}_2$, et qui délivre le bit décodé $I\hat{X}_2$.

Les bits $\hat{X}_1$, $\hat{X}_4$, $\hat{X}_5$, $\hat{X}_6$, $\hat{X}_7$ ne sont pas décodés et sont identiques respectivement aux bits de sortie $I\hat{X}_1$, $I\hat{X}_4$, $I\hat{X}_5$, $I\hat{X}_6$, $I\hat{X}_7$.

Pour décoder un codage externe, formé de deux codages Reed-Solomon et de deux entrelacements, à l'aide d'un seul décodeur Reed-Solomon, l'invention concerne également un procédé de décodage.

L'invention concerne également un procédé de décodage de signaux numériques, mis en oeuvre dans un système de modulation/démodulation, lesdits signaux étant transmis selon une modulation codée par un canal de transmission, lesdits signaux ayant subi un codage de protection par un ajout de redondance binaire répartie sur plusieurs durées-symbole de la modulation codée, le codage de protection comprenant un codage interne combiné avec la modulation codée. Dans le cas où ledit système met en outre en oeuvre une répartition de la redondance binaire entre le codage interne et un codage externe effectué par deux codages Reed-Solomon et deux entrelacements, l'invention est remarquable en ce que le procédé opère selon les étapes suivantes :

A1 -désentrelacement de premiers blocs de signaux par macro-blocs BBi regroupant plusieurs premiers blocs successifs,

A2 -désentrelacement de seconds blocs de signaux par macro-blocs AAj regroupant plusieurs seconds blocs successifs antérieurs auxdits premiers blocs BBi,

B1 -séparation de premiers blocs erronés et de premiers blocs corrects,

B2 -séparation de seconds blocs erronés et de seconds blocs corrects

C1 -détermination du nombre de premiers blocs erronés à décoder

C2 -détermination du nombre de seconds blocs erronés à décoder,

D -puis, d'une part, décodage soit des premiers blocs erronés soit des seconds blocs erronés selon leur ordre d'apparition lorsqu'ils ne se présentent pas simultanément, et, d'autre part, décodage en priorité, des seconds blocs erronés lorsque les premiers et les seconds blocs erronés requièrent simultanément d'être décodés

E -extraction des premiers et seconds blocs corrects et des premiers et seconds blocs décodés.

## Revendications

1. Système de modulation/démodulation de signaux numériques opérant selon une modulation codée en treillis sur un canal de transmission (15), ledit système comprenant un dispositif de codage (5) muni d'un modulateur (13) situés dans une station émettrice et un dispositif de décodage (105) muni d'un démodulateur (113) et d'un décodeur de canal (112) situés dans une station réceptrice, le dispositif de codage (5) comprenant un codeur de canal (12) qui opère un codage de protection des signaux numériques par ajout de redondance binaire répartie sur plusieurs durées-symbole de la modulaion codée, le codeur de canal (12) comprenant au moins un codeur interne (24) qui opère un codage interne convolutif (33) de rendement R2 combiné à la modulation codée par un organe d'affectation binaire, le décodeur de canal (112) comprenant un décodeur interne (124) comportant au moins un décodeur convolutif (133), caractérisé en ce que le codeur de canal (12) comprend en outre un codeur externe (22) qui opère un codage externe avec un rendement R1, le codeur interne (24) comprenant un codeur différentiel (31), placé avant le codeur convolutif (33), pour établir une invariance rotationnelle du codage convolutif, la redondance binaire du codage de protection du codeur de canal (12) étant partagée entre le codeur interne (24) et le codeur externe (22) de sorte que les codages interne et externe concaténés assurent un rendement de codage global R=R1.R2, le décodeur interne (124) étant en série avec un décodeur externe (122) pour décoder ensemble les codages interne et externe concaténés, le décodeur interne (124) comprenant un décodeur différentiel (131) placé après le décodeur convolutif (133) pour effectuer l'inverse de l'opération établissant l'invariance rotationnelle effectuée au codage.

2. Système selon la revendication 1 caractérisé en ce que le codage externe est obtenu par au moins deux codages en blocs cascadés (90, 92) et en ce que le dispositif de décodage (105) comprend un seul décodeur externe (192) pour effectuer les décodages des deux codages en blocs.

3. Système selon la revendication 2 caractérisé en ce qu'un rendement de codage global $R=^3/_4$ est obtenu par un codeur externe de rendement $R_1=^6/_7$ suivi par un codeur interne de rendement $R_2=^7/_8$.

4. Système selon la revendication 3 caractérisé en ce que le codeur convolutif code des bits d'entrée $X_i$ (i=1 à 7) en bits de sortie $Y_j$ (j=1 à 8) tel que les bits $X_3$, $X_4$, $X_5$, $X_6$, $X_7$ deviennent sans codage respectivement les bits $Y_2$, $Y_5$, $Y_6$, $Y_7$, $Y_8$, les bits de sortie restants étant codés par le codeur convolutif qui comprend :

- un premier opérateur-retard (71) opérant sur $X_2$,
- un second opérateur-retard (72) opérant sur $X_1$,
- un troisième opérateur-retard (73) opératnt sur $X_1$ retardé,
- une première porte OU-exclusif (74) qui reçoit : $X_3$, $X_2$ et $X_2$ retardé,
- une seconde porte OU-exclusif (75) qui reçoit : $X_2$ retardé, $X_1$ et $X_1$ retardé deux fois, et qui délivre $Y_1$,
- une porte ET (76) qui reçoit $X_1$ retardé une fois et la sortie de la seconde porte OU-exclusif (75),
- une troisième porte OU-exclusif (77) qui reçoit les sorties de la première porte OU-exclusif (74) et de la porte ET (76) et qui délivre $Y_4$,
- une quatrième porte OU-exclusif (78) qui reçoit les sorties de la seconde porte OU-exclusif (75) et du second opérateur-retard (72) et qui délivre $Y_3$.

5. Système selon la revendication 4 caractérisé en ce que le codeur différentiel code des bits d'entrée $IX_i$ (i=1 à 7) en bits de sortie $X_i$ (i=1 à 7) tel que les bits $IX_4$, $IX_5$, $IX_6$, $IX_7$ deviennent sans codage respectivement les bits $X_4$, $X_5$, $X_6$, $X_7$, les bits de sortie restants étant codés par le codeur différentiel qui comprend:

- un quatrième opérateur-retard (80) opérant sur $Y_1$ suivi d'un inverseur (84),
- un cinquième opérateur-retard (82) opérant sur la sortie $X_3$,
- un sixième opérateur-retard (83) opérant sur $X_2$,
- une autre porte ET (86) qui reçoit la sortie de l'inverseur (84) et $Y_1$,
- une cinquième porte OU-exclusif (85) qui reçoit la sortie de la porte ET (86), la sortie du cinquième opérateur-retard (82) et l'entrée $IX_3$ et qui délivre le bit codé $X_3$,
- une sixième porte OU-exclusif (87) qui reçoit la sortie du sixième opérateur-retard (83) et l'entrée $IX_2$, et qui délivre le bit codé $X_2$.

6. Système selon la revendication 3 caractérisé en ce que l'organe d'affectation binaire opère l'affectation binaire des symboles selon le tableau de correspondance suivant, avec I et Q représentant respectivement les composantes en phase et en quadrature des signaux représentant les symboles d'une constellation :

- sous-ensemble $C_0$

| I | Q | Affectation binaire |
|---|---|---|
| 1 | 1 | 00,00 |
| 1 | -3 | 01,00 |
| -3 | 1 | 11,00 |
| -3 | -3 | 10,00 |

- sous-ensemble $C_1$

| I | Q | Affectation binaire |
|---|---|---|
| -1 | 1 | 00,01 |
| -1 | -3 | 11,01 |
| 3 | 1 | 01,01 |
| 3 | -3 | 10,01 |

- sous-ensemble $C_2$

| I | Q | Affectation binaire |
|---|---|---|
| -1 | -1 | 00,10 |
| -1 | 3 | 01,10 |
| 3 | -1 | 11,10 |
| 3 | 3 | 10,10 |

- sous-ensemble $C_3$

| I | Q | Affectation binaire |
|---|---|---|
| 1 | -1 | 00,11 |
| 1 | 3 | 11,11 |
| -3 | -1 | 01,11 |
| -3 | 3 | 10,11 |

**7.** Système selon la revendication 2 caractérisé en ce que le codeur externe comprend en série un codeur Reed-Solomon RS1, un entrelaceur 1, un codeur Reed-Solomon RS2 et un entrelaceur 2.

**8.** Système selon la revendication 2 caractérisé en ce que le dispositif de décodage comprend :

- un premier étage qui effectue, pour le premier codage externe, un premier désentrelacement (193) et qui sépare entre eux des premiers blocs erronés (197) et des premiers blocs corrects (196),
- un premier organe de test (142) qui détermine un nombre de premiers blocs erronés et qui délivre un signal de test TST2,
- un décodeur Reed-Solomon (192) qui reçoit lesdits premiers blocs erronés (197) du premier étage et fournit des premiers blocs corrigés (198),
- un premier commutateur (194), commandé par le signal TST2, qui commute lesdits premiers blocs corrects (196) et lesdits premiers blocs corrigés (198) vers un second étage,
- un second étage qui effectue, pour le codage externe suivant, un second désentrelacement (191) et qui sépare entre eux des seconds blocs erronés (201) et des seconds blocs corrects (200), lesdits seconds blocs erronés étant introduits à l'entrée du décodeur Reed-Solomon (192) qui délivre des seconds blocs corrigés (199),
- un second organe de test (148) qui détermine un nombre de seconds blocs erronés et qui délivre un second signal de test TST1,
- un second commutateur (195), commandé par le signal TST1, qui commute vers une sortie (202), lesdits seconds blocs corrects (200) et lesdits seconds blocs corrigés (199), le décodeur Reed-Solomon (192) corrigeant en priorité les seconds blocs erronés (201) lorsque les premiers blocs erronés (197) et des seconds blocs erronés (201) antérieurs requièrent simultanément d'être décodés.

**9.** Système selon la revendication 8 caractérisé en ce que le premier organe de test (resp. le second) effectue une division d'une première (resp. une seconde) suite de blocs successifs, formant des macro-blocs, par un premier (resp. un second) polynôme générateur du premier codage (resp. du codage suivant) Reed-Solomon, chaque bloc erroné étant détecté lorsque la division ne délivre pas un reste nul.

**10.** Procédé de codage/décodage de signaux numériques, utilisé dans un système de modulation/démodulation selon la revendication 1 dans lequel lesdits signaux étant transmis selon une modulation codée en treillis sur un canal de transmission, lesdits signaux ayant subi un codage de protection par un ajout de redondance binaire répartie sur plusieurs durées-symbole de la modulation codée, le codage de protection comprenant un codage interne combiné avec la modulation codée, caractérisé en ce que le procédé utilise en outre une répartition de la redondance binaire entre le codage interne et un codage externe effectué par deux codages Reed-Solomon et deux entrelacements, et pour décoder le codage externe, le procédé opère selon les étapes suivantes:

> A1- désentrelacement (193) de premiers blocs de signaux par macro-blocs BBi regroupant plusieurs premiers blocs successifs,
>
> A2- désentrelacement (191) de seconds blocs de signaux par macro-blocs AAj regroupant plusieurs seconds blocs successifs antérieurs auxdits premiers blocs BBi,
>
> B1- séparation de premiers blocs erronés (197) et de premiers blocs corrects (196),
>
> B2- séparation de seconds blocs erronés (201) et de seconds blocs corrects (200),
>
> C1- détermination (150, 152) du nombre de premiers blocs erronés à décoder,
>
> C2- détermination (150, 152) du nombre de seconds blocs erronés à décoder,
>
> D- puis, d'une part, décodage (192) soit des premiers blocs erronés (197) soit des second blocs erronés (201) selon leur ordre d'apparition lorsqu'ils ne se présentent pas simultanément, et, d'autre part, décodage en priorité des seconds blocs erronés (201) lorsque les premiers (197) et les seconds (201) blocs erronés requièrent simultanément d'être décodés,
>
> E- extraction (202) des premiers (196) et des seconds (200) blocs corrects et des premiers et des seconds blocs décodés (199).

11. Emetteur pour une utilisation dans un système de modulation/démodulation de signaux numériques opérant selon une modulation codée en treillis sur un canal de transmission (15), l'émetteur comprenant un dispositif de codage (5) muni d'un modulateur (13), le dispositif de codage (5) comprenant un codeur de canal (12) qui opère un codage de protection des signaux numériques par ajout de redondance binaire répartie sur plusieurs durées-symbole de la modulation codée, le codeur de canal (12) comprenant au moins un codeur interne (24) qui opère un codage interne convolutif (33) de rendement R2 combiné à la modulation codée par un organe d'affectation binaire, caractérisé en ce que le codeur de canal (12) comprend en outre un codeur externe (22) qui opère un codage externe avec un rendement R1, le codeur interne (24) comprenant un codeur différentiel (31), placé avant le codeur convolutif (33), pour établir une invariance rotationnelle du codage convolutif, la redondance binaire du codage de protection du codeur de canal (12) étant partagée entre le codeur interne (24) et le codeur externe (22) de sorte que les codages interne et externe concaténés assurent un rendement de codage global R=R1.R2.

12. Récepteur pour une utilisation dans un système de modulation/démodulation de signaux numériques opérant selon une modulation codée en treillis sur un canal de transmission (15), le récepteur comprenant un dispositif de décodage (105) muni d'un démodulateur (113) et d'un décodeur de canal (12) comprenant un décodeur interne (124) comportant un décodeur convolutif (133), caractérisé en ce que le décodeur interne (124) est en série avec un décodeur externe (122) pour décoder ensemble des codages interne et externe concaténés opérés à l'émission, le décodeur interne (124) comprenant un décodeur différentiel (131), placé après le décodeur convolutif (133), pour effectuer l'inverse d'une opération établissant une invariance rotationnelle d'un codage convolutif effectué à l'émission.

13. Récepteur selon la revendication 12 caractérisé en ce que le dispositif de décodage (105) comprend un seul décodeur externe (192) pour effectuer des décodages des deux codages externes en blocs (90, 92) opérés à l'émission.

**Patentansprüche**

1. Ein System zur Modulierung/Demodulierung digitaler Signale, das mit kodierter Modulation auf einem Übertragungskanal (15) arbeitet, das besagte System beinhaltet eine mit einem Modulator (13) versehene Kodiereinrichtung (5) in einer Übertragungsstation und eine mit einem Demodulator (113) versehene Dekodiereinrichtung (105) und einen Kanaldekodierer (112) in einer Empfangsstation, die Kodiereinrichtung (5) beinhaltet einen Kanalkodierer (12), der eine Schutzkodierung der digitalen Signale bewirkt, indem er auf mehrere Symboldauern der kodierten Modulation verteilte binäre Redundanz hinzufügt, der Kanalkodierer (12) beinhaltet mindestens einen internen Kodierer (24), der eine interne, einrollende Kodierung (33) der Leistung R2 in Verbindung mit der kodierten Modulation durch eine binäre Zuteilungsvorrichtung bewirkt, der Kanaldekodierer (112) beinhaltet einen internen Dekodierer (124), der mindestens einen einrollenden Dekodierer (133) beinhaltet, mit dem Merkmal, daß der Kanalkodierer (12) zusätzlich über einen externen Kodierer (22) verfügt, der einen externen Kode mit einer Leistung R1 bewirkt, der interne Kodierer (24) beinhaltet einen vor dem einrollenden Kodierer (33) angebrachten Differentialkodierer (31) zur Erstellung einer rotierenden Invarianz der einrollenden Kodierung, wobei die binäre Redundanz der Schutzkodierung des Kanalkodierers (12) derart zwischen dem internen Kodierer (24) und dem externen Kodierer (22) aufgeteilt ist, daß die internen und externen Verkettungen eine globale Kodierleistung R=R1.R2 versichern, wobei der interne Dekodierer (124) in Serie mit einem externen Dekodierer (122) steht, um gemeinsam die verketteten internen und externen Kodierungen zu dekodieren und der interne Dekodierer (124) über einen nach dem einrollenden Dekodierer (133) angebrachten Differentialdekodierer (131) verfügt, um die Umkehrung des bei der Kodierung durchgeführten Vorgangs zur Erstellung der rotierenden Invarianz vorzunehmen.

2. Ein System laut Anspruch 1, mit dem Merkmal, daß die externe Kodierung durch mindestens zwei Blockkodierungen in Kaskade (90, 92) erhalten wird und die Dekodiereinrichtung (105) über einen einzigen externen Dekodierer (192) zur Durchführung der Dekodierungen der beiden Blockkodierungen verfügt.

3. Ein System laut Anspruch 2, mit dem Merkmal, daß eine globale Kodierleistung $R={}^3/_4$ mit einem externen Kodierer der Leistung $R_1={}^6/_7$, gefolgt von einem internen Kodierer der Leistung $R_2={}^7/_8$ erreicht wird.

4. Ein System laut Anspruch 3, mit dem Merkmal, daß der einrollende Kodierer eingehende Bits $X_i$ (i=1 bis 7) derart in ausgehende Bits $Y_j$ (j=1 bis 8) kodiert, daß die Bits $X_3$, $X_4$, $X_5$ $X_6$, $X_7$ ohne jeweilige Kodierung zu den Bits $Y_2$, $Y_5$, $Y_6$, $Y_7$, $Y_8$ werden, wobei die verbleibenden ausgehenden Bits von einem einrollenden Kodierer kodiert werden, der beinhaltet :

- einen ersten, auf $X_2$ operierenden Verzögerungsoperator (71),
- einen zweiten, auf $X_1$ operierenden Verzögerungsoperator (72),
- einen dritten, auf dem verzögerten $X_1$ operierenden Verzögerungsoperator (73),
- ein erstes ausschließliches ODER-Tor (74), das erhält : $X_3$, $X_2$ und $X_2$ verzögert,
- ein zweites ausschließliches ODER-Tor (75), das erhält : $X_2$ verzögert, $X_1$ und $X_1$ zweimal verzögert, und $Y_1$ abgibt,
- ein UND-Tor (76), das $X_1$ einmal verzögert und den Ausgang des zweiten ausschließlichen ODER-Tors (75) erhält,
- ein drittes ausschließliches ODER-Tor (77), das die Ausgänge de ersten exkklusiven ODER-Tors (74) und des UND-Tors (76) erhält und $Y_4$ abgibt,
- ein viertes ausschließliches ODER-Tor (78), das die Ausgänge des zweiten ausschließlichen ODER-Tors (75) und des zweiten Verzögerungsoperator (72) erhält und $Y_3$ abgibt.

5. Ein System laut Anspruch 4, mit dem Merkmal, daß der Differentialkodierer eingehende Bits $IX_i$ (i=1 bis 7) derart in ausgehende Bits $X_i$ (i=1 bis 7) kodiert, daß die Bits $IX_4$, $IX_5$, $IX_6$, $IX_7$ ohne jeweilige Kodierung zu den Bits $X_4$, $X_5$, $X_6$, $X_7$ werden, wobei die verbleibenden ausgehenden Bits von einem Differentialkodierer kodiert werden, der beinhaltet :

- einen vierten, auf $Y_1$ operierenden Verzögerungsoperator (80), gefolgt von einem Umkehrer (84),
- einen fünften, auf dem Ausgang $X_3$ operierenden Verzögerungsoperator (82),
- einen sechsten, auf den Ausgang $X_2$ operierenden Verzögerungsoperator (83),
- ein anderes UND-Tor (86), das den Ausgang des Umkehrers (84) und $Y_1$ erhält,
- ein fünftes ausschließliches ODER-Tor (85), das den Ausgang des UND-Tors (86), den Ausgang des Verzögerungsoperators (82) und den Ausgang $IX_3$ erhält und das kodierte Bit $X_3$ abgibt,
- ein sechstes ausschließliches ODER-Tor (87), das den Ausgang des sechsten Verzögerungsoperators (83) und den Eingang $IX_2$ erhält und das kodierte Bit $X_2$ abgibt.

6. Ein System laut Anspruch 3, mit dem Merkmal, daß die binäre Zuteilungvorrichtung die binäre Zuteilung der Symbole laut der folgenden Entsprechungstabelle vornimmt, wobei I und Q jeweils die Komponente in der Phase und Quadratur für die Symbole darstellenden Signale einer Konstellation stehen :

- Untersystem $C_0$

| I | Q | binäre Zuteilung |
|---|---|---|
| 1 | 1 | 00,00 |
| 1 | -3 | 01,00 |
| -3 | 1 | 11,00 |
| -3 | -3 | 10,00 |

- Untersystem $C_1$

| I | Q | binäre Zuteilung |
|---|---|---|
| -1 | 1 | 00,01 |
| -1 | -3 | 11,01 |
| 3 | 1 | 01,01 |
| 3 | -3 | 10,01 |

- Untersystem $C_2$

| I | Q | binäre Zuteilung |
|---|---|---|
| -1 | 1 | 00,10 |
| -1 | 3 | 01,10 |
| 3 | -1 | 11,10 |
| 3 | 3 | 10,10 |

- Untersystem $C_3$

| I | Q | binäre Zuteilung |
|---|---|---|
| 1 | -1 | 00,11 |
| 1 | 3 | 11,11 |
| -3 | -1 | 01,11 |
| -3 | 3 | 10,11 |

7. Ein System laut Anspruch 2, mit dem Merkmal, daß der externe Kodierer in Serie einen Reed-Solomon-Kodierer RS1, einen Verflechter 1, einen Reed-Solomon-Kodierer RS2 und einen Verflechter 2 enthält.

8. Ein System laut Anspruch 2, mit dem Merkmal, daß die Kodiereinrichtung folgendes enthält :

- eine erste Stufe, die für die erste externe Kodierung eine erste Entflechtung (193) vornimmt und die ersten fehlerhaften Blöcke (197) von den ersten korrekten Blöcken (196) trennt,
- eine erste Testvorrichtung (142) zur Bestimmung der Anzahl erster fehlerhafter Blöcke, die ein Testsignal TST2 liefert,
- einen Reed-Solomon-Dekodierer (192), der die besagten ersten fehlerhaften Blöcke (197) der ersten Stufe erhält und die ersten korrigierten Blöcke (198) liefert,

- einen ersten vom Signal TST2 gesteuerten Schalter (194), der die besagten ersten korrekten Blöcke (196) und die besagten ersten korrigierten Blöcke (198) zu einer zweiten Stufe leitet,
- eine zweite Stufe, die für die darauffolgende externe Kodierung eine zweite Entflechtung (191) vornimmt und die zweiten fehlerhaften Blöcke (201) von den zweiten korrekten Blöcken (200) trennt, die besagten zweiten fehlerhaften Blöcke werden in den Eingang des Reed-Solomon-Dekodierers (192) geführt, der die zweiten korrigierten Blöcke (199) abgibt,
- eine zweite Testvorrichtung (148) zur Bestimmung der Anzahl zweiter fehlerhafter Blöcke, die ein zweites Testsignal TST1 liefert,
- einen zweiten vom Signal TST1 gesteuerten Schalter (195), der die besagten zweiten korrekten Blöcke (200) und die besagten zweiten korrigierten Blöcke (199) zu einem Ausgang (202) leitet, der Reed-Solomon-Dekodierer (192) korrigiert vorrangig die zweiten fehlerhaften Blöcke (201), wenn die ersten fehlerhaften Blöcke (197) und zweite fehlerhafte, vorherige Blöcke (201) zugleich dekodiert werden müssen.

9. Ein System laut Anspruch 8, mit dem Merkmal, daß die erste Testvorrichtung (resp. die zweite) eine Teilung einer ersten (resp. einer zweiten) aufeinanderfolgenden Blockreihe vornimmt, die durch einen ersten (resp. einen zweiten) polynomen Erzeuger der ersten Reed-Solomon-Kodierung (resp. der darauffolgenden Kodierung) Makroblöcke bildet, wobei jeder fehlerhafte Block erfaßt wird, wenn er nicht einen Rest null ergibt.

10. Ein Kodier/Dekodier-Verfahren digitaler Signale, verwendet in einem Modulations/Demodulations-System laut Anspruch 1, in dem die besagten Signale nach einer kodierten Modulierung in einem Netzwerk über einen Übertragungskanal übertragen werden, die besagten Signale wurden durch Hinzufügen binärer, auf mehrere Symboldauern der kodierten Modulation verteilten Redundanz einer Schutzkodierung unterworfen, die Schutzkodierung beinhaltet eine interne, mit der kodierten Modulation verbundene Kodierung, mit dem Merkmal, daß das Verfahren außerdem eine Aufteilung der binären Redundanz zwischen der internen und der externen Kodierung durch zwei Reed-Solomon-Kodierungen und zwei Verflechtungen vornimmt und das Verfahren zur Dekodierung der externen Kodierung nach folgenden Schritten vorgeht :

A1 - Entflechtung (193) der ersten Signalblöcke durch Makroblöcke BBi, die mehrere erste aufeinanderfolgende Blöcke zusammenstellen,
A2 - Entflechtung (191) der zweiten Signalblöcke durch Makroblöcke AAj, die mehrere zweite aufeinanderfolgende, vor den besagten ersten Blöcken BBi liegende Blöcke zusammenstellen,
B1 - Trennung der ersten fehlerhaften Blöcke (197) und der ersten korrekten Blöcke (196),
B2 - Trennung der zweiten fehlerhaften Blöcke (201) und der zweiten korrekten Blöcke (200),
C1 - Bestimmung (150, 152) der Anzahl erster fehlerhafter, zu dekodierender Blöcke,
C2 - Bestimmung (150, 152) der Anzahl zweiter fehlerhafter, zu dekodierender Blöcke,
D - daraufhin einerseits Dekodierung (192) entweder der ersten fehlerhaften Blöcke (197) oder der zweiten fehlerhaften Blöcke (201) der Reihe ihres Auftretens nach, wenn sie nicht gleichzeitig auftreten, und andererseits vorrangige Dekodierung der zweiten fehlerhaften Blöcke (201), wenn die ersten (197) und die zweiten (201) fehlerhaften Blöcke eine gleichzeitige Dekodierung erfordern,
E - Entnahme (202) der ersten (196) und zweiten (200) korrekten Blöcke und der ersten und zweiten dekodierten Blöcke (199).

11. Ein Sender zur Verwendung in einem Modulations/Demodulations-System digitaler Daten, arbeitend nach einer kodierten Modulierung in einem Netzwerk über einen Übertragungskanal (15), der Sender beinhaltet eine mit einem Modulator (13) versehene Kodiereinrichtung (5), die einen Kanalkodierer (12) beinhaltet, der eine Schutzkodierung der digitalen Signale bewirkt, indem er auf mehrere Symboldauern der kodierten Modulation verteilte binäre Redundanz hinzufügt, der Kanalkodierer (12) beinhaltet mindestens einen internen Kodierer (24), der eine interne, einrollende Kodierung (33) der Leistung R2 in Verbindung mit der kodierten Modulation durch eine binäre Zuteilungsvorrichtung bewirkt, mit dem Merkmal, daß der Kanalkodierer (12) zusätzlich über einen externen Kodierer (22) verfügt, der einen externen Kode mit einer Leistung R1 bewirkt, der interne Kodierer (24) beinhaltet einen vor dem einrollenden Kodierer (33) angebrachten Differentialkodierer (31) zur Erstellung einer rotierenden Invarianz der einrollenden Kodierung, wobei die binäre Redundanz der Schutzkodierung des Kanalkodierers (12) derart zwischen dem internen Kodierer (24) und dem externen Kodierer (22) aufgeteilt ist, daß die internen und externen Verkettungen eine globale Kodierleistung R=R1.R2 versichern.

12. Ein Empfänger zur Verwendung in einem Modulations/Demodulations-System digitaler Daten, arbeitend nach einer kodierten Modulierung in einem Netzwerk über einen Übertragungskanal (15), der Empfänger beinhaltet eine mit einem Demodulator (113) versehene Dekodiereinrichtung (105) und einen Kanaldekodierer (12) beinhaltend einen internen Dekodierer (124) mit einem einrollenden Dekodierer (133), mit dem Merkmal daß der interne Dekodierer (124) in Serie mit einem externen Dekodierer (122) steht, um gemeinsam die beim Senden vorgenommenen verketteten internen und externen Kodierungen zu dekodieren, und, daß der interne Dekodierer (124) über einen nach dem einrollenden Dekodierer (133) angebrachten Differentialdekodierer (131) verfügt, um die Umkehrung des beim Senden durchgeführten Vorgangs zur Erstellung der rotierenden Invarianz vorzunehmen.

**13.** Ein Empfänger laut Anspruch 12, mit dem Merkmal, daß die Dekodiereinrichtung (105) einen einzigen externen Dekodierer (192) zur Durchführung der Dekodierungen der beiden externen, beim Senden vorgenommenen Blockkodierungen (90, 92) beinhaltet.

## Claims

1. Digital signal modulating/demodulating system which operates according to a trellis-coded modulation on a transmission channel (15), said system comprising a coding device (5) equipped with a modulator (13) which is situated in a transmitting station and a decoding device (105) equipped with a demodulator (113) and a channel decoder (112) which is situated in a receiving station, the coding device (5) comprising a channel coder (12) which executes a coding for protecting the digital signals by adding redundancy bits distributed over several symbol periods of the coded modulation, the channel coder (12) comprising at least one internal coder (24) which executes an internal convolutive coding (33) with an efficiency of R2 combined with the modulation coded by a binary allocation element, the channel decoder (112) comprising an internal decoder (124) which comprises at least one convolutive decoder (133), characterized in that the channel coder (12) further comprises an external coder (22) which performs an external coding with an efficiency of R1, the internal coder (24) comprising a differential coder (31), arranged upstream of the convolutive coder (33), for establishing a rotational invariance of the convolutive coder, the bit redundancy of the protective coding of the channel coder (12) being divided between the internal coder (24) and the external coder (22), so that the concatenated internal and external codings ensure an approximate efficiency of R=R1.R2, the internal decoder (124) being connected in series to an external decoder (122) to decode together the concatenated internal and external codings, the internal decoder (124) comprising a differential decoder (131) arranged downstream of the convolutive decoder (133) to effect the reverse operation to the one that establishes the rotational invariance effected during the coding.

2. System as claimed in Claim 1, characterized in that the external coding is obtained by at least two cascaded block codings (90, 92) and in that the decoding device (105) comprises a single external decoder (192) for performing the decoding of the two block codings.

3. System as claimed in Claim 2, characterized in that an approximate coding efficiency $R=^3/_4$ is obtained by an external coder with an efficiency of $R_1 =^6/_7$ followed by an internal coder with an efficiency of $R_2=^7/_8$.

4. System as claimed in Claim 3, characterized in that the convolutive coder codes input bits $X_i$ ($i = 1$ to 7) into output bits $Y_j$ ($j = 1$ to 8) such that the bits $X_3$, $X_4$, $X_5$, $X_6$, $X_7$ become, without coding the bits $Y_2$, $Y_5$, $Y_6$, $Y_7$, $Y_8$ respectively, the remaining output bits being coded by the convolutive coder which comprises :

   - a first delay-operator (71) influencing $X_2$
   - a second delay-operator (72) influencing $X_1$
   - a third delay-operator (73) influencing delayed $X_1$
   - a first exclusive OR gate (74) which receives : delayed $X_3$, $X_2$ and $X_2$
   - a second exclusive OR gate (75) which receives : $X_2$ delayed, $X_1$ and $X_1$ delayed twice, and which produces $Y_1$
   - an AND gate (76) which receives $X_1$ delayed once and the output from the second exclusive OR gate
   - a third exclusive OR gate (77) which receives the outputs from the first exclusive OR gate (74) and from the AND gate (76) and which produces $Y_4$
   - a fourth exclusive OR gate (78) which receives the outputs from the second exclusive OR gate (75) and from the second delay-operator (72) and which produces $Y_3$.

5. System as claimed in Claim 4, characterized in that the differential coder codes input bits $IX_i$ ($i = 1$ to 7) into output bits $X_i$ ($i = 1$ to 7) so that the bits $IX_4$, $IX_5$, $IX_6$, $IX_7$ become, without coding, the bits $X_4$, $X_5$, $X_6$, $X_7$ respectively, the remaining output bits being coded by the differential coder which comprises :

- a fourth delay-operator (80) influencing $Y_1$ followed by an inverter (84)
- a fifth delay-operator (82) influencing the output $X_3$
- a sixth delay-operator (83) influencing $X_2$
- another AND gate (86) which receives $Y_1$ and the output from the inverter (84)
- a fifth exclusive OR gate (85) which receives the output from another AND gate (86), the output from the fifth delay-operator (82) and the input $IX_3$ and which produces the coded bit $X_3$
- a sixth exclusive OR gate (87) which receives the output from the sixth delay-operator (83) and the input $IX_2$, and which produces the coded bit $X_2$.

6. System as claimed in Claim 3, characterized in that the bit allocation module executes the bit allocation of the symbols according to the following correspondence table, with I and Q representing the phase and quadrature components respectively, of the signals that represent the symbols of a constellation :

- subset $C_0$

| I | Q | bit allocation |
|---|---|---|
| 1 | 1 | 00,00 |
| 1 | -3 | 01,00 |
| -3 | 1 | 11,00 |
| -3 | -3 | 10,00 |

- subset $C_1$

| I | Q | bit allocation |
|---|---|---|
| -1 | 1 | 00,01 |
| -1 | -3 | 11,01 |
| 3 | 1 | 01,01 |
| 3 | -3 | 10,01 |

- subset $C_2$

| I | Q | bit allocation |
|---|---|---|
| -1 | -1 | 00,10 |
| -1 | 3 | 01,10 |
| 3 | -1 | 11,10 |
| 3 | 3 | 10,10 |

- subset $C_3$

| I | Q | bit allocation |
|---|---|---|
| 1 | 1 | 00,11 |
| 1 | 3 | 11,11 |
| -3 | -1 | 01,11 |
| -3 | 3 | 10,11 |

7. System as claimed in Claim 2, characterized in that the external coder comprises, in series, a Reed-Solomon coder RS1, an interleaver 1, a Reed-Solomon coder RS2 and an interleaver 2.

8. System as claimed in Claim 2, characterized in that the decoding device comprises:

- a first stage which performs, for the first coding, a first deinterleaving (193) and which separates first erroneous blocks (197) and first correct blocks (196) from each other,
- a first test module (142) which determines a number of first erroneous blocks and which delivers a test signal TST2,
- a Reed-Solomon decoder (192) which receives said first erroneous blocks (197) from the first stage and produces first corrected blocks (198),
- a first switch (194), controlled by the signal TST2, which switches said first correct blocks (196) and said first corrected blocks (198) to a second stage,
- a second stage which performs, for the following external coding, a second deinterleaving (191) and which separates second erroneous blocks (201) and second correct blocks (200) from each other, said second erroneous blocks being inserted at the input of the Reed-Solomon decoder (192) which produces second corrected blocks (199),
- a second test module (148) which determines a number of second erroneous blocks and which produces a second test signal TST1,
- a second switch (195), controlled by the signal TST1, which switches to an output (202) said second correct blocks (200) and said second corrected blocks (199), the Reed-Solomon decoder (192) correcting with priority the second erroneous blocks (201) when the first erroneous blocks (197) and earlier second erroneous blocks (201) simultaneously require to be decoded.

9. System as claimed in Claim 8, characterized in that the first test module (the second, respectively) performs a division of a first (a second, respectively) string of successive blocks, forming macroblocks, by a first (a second, respectively) generator polynomial for the first Reed-Solomon coding (the following coding, respectively), each erroneous block being detected when the division does not produce a zero remainder.

10. Method of coding/decoding digital signals, implemented in a modulation/demodulation system as claimed in Claim 1, in which said signals are transmitted according to a trellis-coded modulation by a transmission channel, said signals having undergone a protection coding by an addition of bit redundancy distributed over several symbol periods of the coded modulation, the protection coding comprising an internal coding combined with the coded modulation, characterized in that said method also implements a distribution of the bit redundancy between the internal coding and an external coding performed by two Reed-Solomon codings and two interleavings, and for decoding the external coding the method operates according to the following steps :

A1 - deinterleaving (193) of first blocks of signals by macroblocks BBi grouping together several first successive blocks,
A2 - deinterleaving (191) of second blocks of signals by macroblocks AAj grouping together several second successive blocks earlier than said first blocks BBi,
B1 - separating of first erroneous blocks (197) and of first correct blocks (196),
B2 - separating of second erroneous blocks (201) and of second correct blocks (200),
C1 - determining (150, 152) the number of first erroneous blocks to be decoded
C2 - determining (150, 152) the number of second erroneous blocks to be decoded
D - then, on the one hand, decoding (192) either the first erroneous blocks (197) or the second erroneous blocks (201) depending on their order of appearance when they do not arrive simultaneously, and, on the other hand, priority decoding, of the second erroneous blocks (201) when the first (197) and the second erroneous blocks (201) simultaneously require to be decoded

E - extracting (202) the first (196) and second correct blocks (200) and the first and second decoded blocks (199).

11. Transmitter for use in a digital signal modulating/demodulating system which operates according to a trellis-coded modulation on a transmission channel (15), the transmitter comprising a coding device (5) equipped with a modulator (13), the coding device (5) comprising a channel coder (12) which executes a coding for protecting the digital signals by adding redundancy bits distributed over several symbol periods of the coded modulation, the channel coder (12) comprising at least one internal coder (24) which executes an internal convolutive coding (33) with an efficiency of R2 combined with the modulation coded by a binary allocation element, characterized in that the channel coder (12) further comprises an external coder (22) which performs an external coding with an efficiency of R1, the internal coder (24) comprising a differential coder (31), arranged upstream of the convolutive coder (33), for establishing a rotational invariance of the convolutive coder, the bit redundancy of the protective coding of the channel coder (12) being divided between the internal coder (24) and the external coder (22), so that the concatenated internal and external codings ensure an approximate efficiency of R=R1.R2.

12. Receiver for use in a digital signal modulating/demodulating system which operates according to a trellis-coded modulation on a transmission channel (15), the receiver comprising a decoding device (105) equipped with a demodulator (113) and a channel decoder (112) comprising an internal decoder (124) which comprises a convolutive decoder (133), characterized in that the internal decoder (124) is connected in series to an external decoder (122) to decode together the concatenated internal and external codings performed on transmission, the internal decoder (124) comprising a differential decoder (131) arranged downstream of the convolutive decoder (133) to effect the reverse operation to the one that establishes a rotational invariance of a convolutive coding effected on transmission.

13. Receiver as claimed in Claim 12, characterized in that the decoding device (105) comprises a single external decoder (192) for performing the decoding of the two external block codings (90, 92) performed on transmission.

FIG. 4

FIG. 5

FIG. 6

$$C_0^{(4)} = C_0 C_0 \cup C_2 C_2$$

$$C_4^{(4)} = C_0 C_2 \cup C_2 C_0$$

$B_0 B_0$

$$C_2^{(4)} = C_1 C_1 \cup C_3 C_3$$

$$C_6^{(4)} = C_1 C_3 \cup C_3 C_1$$

$B_1 B_1$

$B_0 B_0 \cup B_1 B_1$

$$A_0^{(4)} = A_0 A_0$$

$$C_1^{(4)} = C_0 C_1 \cup C_2 C_3$$

$$C_5^{(4)} = C_0 C_3 \cup C_2 C_1$$

$B_0 B_1$

$$C_3^{(4)} = C_1 C_2 \cup C_3 C_0$$

$$C_7^{(4)} = C_1 C_0 \cup C_3 C_2$$

$B_1 B_0$

$B_0 B_1 \cup B_1 B_0$

$d_0$     $d_1$     $d_1$     $d_2$

EP 0 481 549 B1

$( C_0^{(4)} , C_2^{(4)} , C_4^{(4)} , C_6^{(4)} )$ 000

$( C_1^{(4)} , C_3^{(4)} , C_5^{(4)} , C_7^{(4)} )$ 010

$( C_6^{(4)} , C_4^{(4)} , C_2^{(4)} , C_0^{(4)} )$ 100

$( C_7^{(4)} , C_5^{(4)} , C_3^{(4)} , C_1^{(4)} )$ 110

$( C_2^{(4)} , C_0^{(4)} , C_6^{(4)} , C_4^{(4)} )$ 001

$( C_3^{(4)} , C_1^{(4)} , C_7^{(4)} , C_5^{(4)} )$ 011

$( C_4^{(4)} , C_6^{(4)} , C_0^{(4)} , C_2^{(4)} )$ 101

$( C_5^{(4)} , C_7^{(4)} , C_1^{(4)} , C_3^{(4)} )$ 111

FIG. 7

FIG. 10

FIG. 8

FIG. 9

FIG. 11

FIG. 12

FIG. 15

FIG. 13

FIG. 14 A

EP 0 481 549 B1

FIG. 14 B

FIG. 14 C

FIG. 16